(19) **Europäisches Patentamt / European Patent Office / Office européen des brevets**

(11) **EP 3 968 523 A1**

(12) **EUROPEAN PATENT APPLICATION**
published in accordance with Art. 153(4) EPC

(43) Date of publication:
**16.03.2022 Bulletin 2022/11**

(21) Application number: **19930633.3**

(22) Date of filing: **31.05.2019**

(51) International Patent Classification (IPC):
**H03L 7/099** (2006.01)    **H03L 7/18** (2006.01)

(52) Cooperative Patent Classification (CPC):
**H03L 7/099; H03L 7/18**

(86) International application number:
**PCT/CN2019/089705**

(87) International publication number:
**WO 2020/237690 (03.12.2020 Gazette 2020/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Technologies Co., Ltd.**
**Longgang District**
**Shenzhen,**
**Guangdong 518129 (CN)**

(72) Inventor: **GAO, Peng**
**Shenzhen, Guangdong 518129 (CN)**

(74) Representative: **Maiwald Patent- und Rechtsanwaltsgesellschaft mbH**
**Elisenhof**
**Elisenstraße 3**
**80335 München (DE)**

(54) **PHASE SYNCHRONIZATION APPARATUS, PHASE SYNCHRONIZATION SYSTEM AND TRANSCEIVING APPARATUS**

(57)    A phase synchronization apparatus, a phase synchronization system, and a transceiver apparatus are disclosed to provide local oscillator signals with a same phase for each radio frequency transceiver chip in a multi-chip combination solution. The phase synchronization system includes a first radio frequency transceiver chip and a second radio frequency transceiver chip. The first radio frequency transceiver chip includes a first phase-locked loop and a first control circuit, and the second radio frequency transceiver chip includes a second phase-locked loop. The first phase-locked loop is configured to generate a first local oscillator signal, and the second phase-locked loop is configured to generate a second local oscillator signal. The first control circuit is configured to: perform detection based on the first local oscillator signal and the second local oscillator signal to obtain a first phase error, generate a first control signal based on the first phase error, and perform phase control on the first phase-locked loop or the second phase-locked loop by using the first control signal.

FIG. 7

## Description

### TECHNICAL FIELD

This application relates to the field of communications technologies, and in particular, to a phase synchronization apparatus, a phase synchronization system, and a transceiver apparatus.

### BACKGROUND

In a fifth generation (5G) mobile communications system, a multi-antenna technology is to be widely used as a core technology for improving a system throughput.

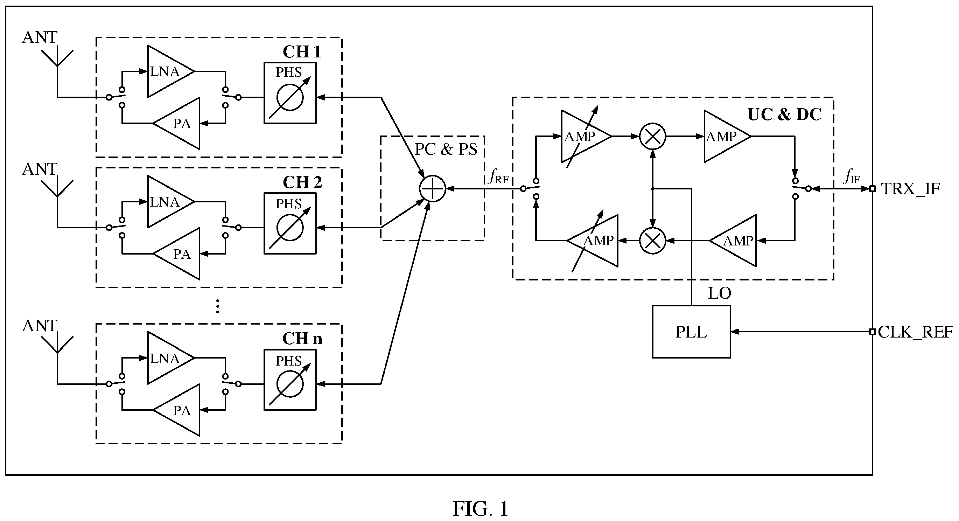

A radio frequency transceiver of a wireless terminal needs to provide a plurality of transceiver channels, to support the multi-antenna technology. FIG. 1 shows a radio frequency transceiver supporting the multi-antenna technology. n radio frequency transceiver channels (CH 1, CH 2, ..., CH n) are integrated into the radio frequency transceiver. Each transceiver channel has basically same circuit composition, and includes a low-noise amplifier (LNA), a power amplifier (PA), a phase shifter (PHS), and the like. A proper phase-shift parameter is configured for the PHS of each transceiver channel. In this way, beamforming may be implemented by using a plurality of antennas (ANTs), to increase an equivalent antenna gain in a specific spatial direction.

In a receive direction, after a signal received by each ANT is amplified by the LNA, a phase shift operation is performed on the signal by the PHS. An equivalent antenna gain in a specific direction may be increased by configuring a phase-shift parameter for each PHS. The phase-shifted received signals are combined into one signal by a power combiner (PC). The signal obtained through combination is transferred to a lower carrier frequency by a down-converter (DC) for processing.

In a transmit direction, baseband signals are frequency-converted into intermediate frequency signals, and then the intermediate frequency signals are sent to a transmitter. The intermediate frequency signals are frequency-converted by an up-converter (UC) for a second time and transferred to a radio frequency carrier frequency. Then, the signals are divided into n signals by a power splitter (PS), and the n signals are respectively sent to the n radio frequency transceiver channels. A PHS phase-shifts a signal sent to each radio frequency transceiver channel, and then a phase-shifted signal is sent by the PA to the ANT and is radiated to free space by the ANT. A proper phase-shift parameter is configured for each PHS. In this way, transmit signals radiated by all ANTs can be combined spatially, to obtain a larger transmit power in a specific spatial direction.

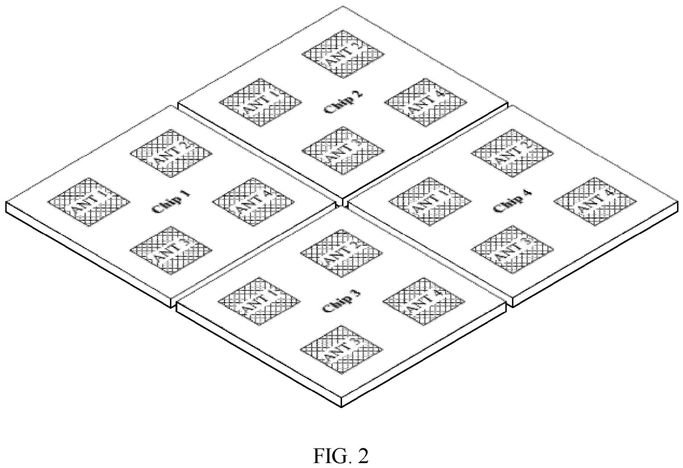

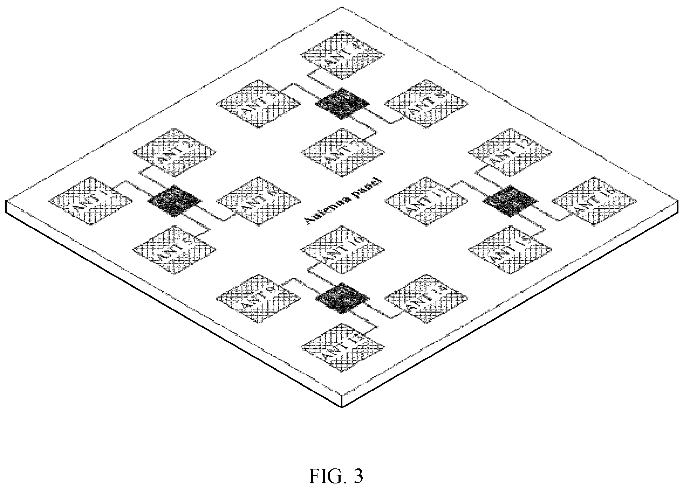

In some application scenarios, more antennas may be used for the system, to further improve beamforming characteristics. Due to limitations such as costs, power consumption, and implementation complexity, a quantity of radio frequency channels that can be provided by one radio frequency transceiver chip is limited. Therefore, a multi-chip combination solution needs to be used to implement antenna array expansion. FIG. 2 shows an example of an antenna array expansion method. In this example, each chip independently supports a 2 x 2 antenna array (ANT 1 to ANT 4), and four identical chips (a chip 1 to a chip 4) are combined to form a 4 x 4 antenna array. This implements antenna array expansion. FIG. 3 shows another implementation of antenna array expansion. In this example, implementation of an antenna array is decoupled from chips, and the chips are connected to antenna feed points through radio frequency conductors.

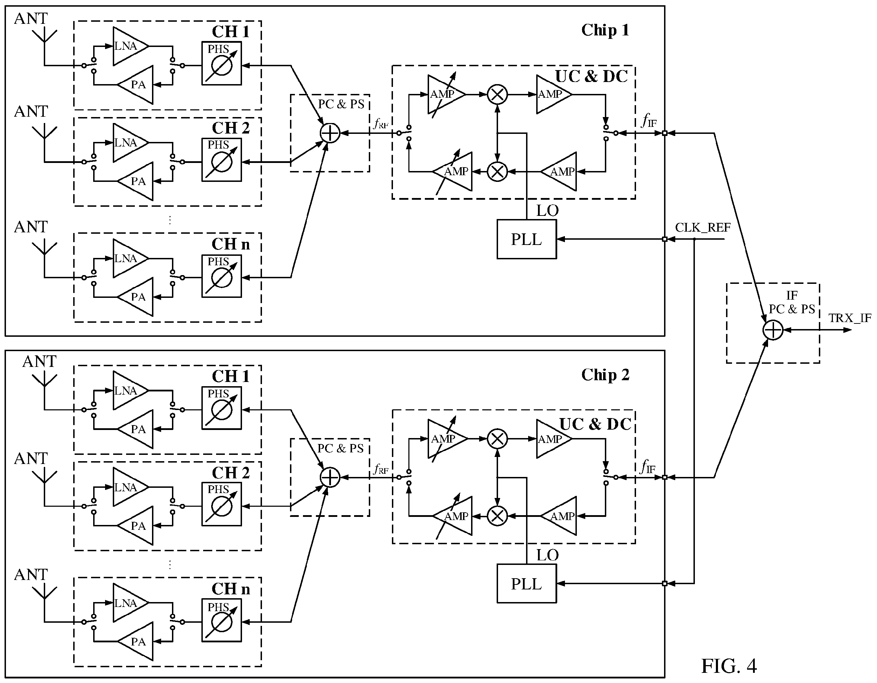

A plurality of radio frequency transceiver chips are used in parallel regardless of an antenna array expansion manner. For example, a radio frequency transceiver shown in FIG. 4 can be applied to a radio frequency system supporting a multi-antenna technology. The radio frequency transceiver shown in FIG. 4 includes two radio frequency transceiver chips, and n radio frequency transceiver channels are integrated into each chip. A phase-locked loop (PLL) in each of the chip 1 and the chip 2 provides a local oscillator signal for an up-conversion operation or a down-conversion operation on the corresponding chip. In other words, the local oscillator signals of the two chips are independent of each other. The phase-locked loops of the two chips use a same reference clock signal (CLK REF). In this way, frequencies of the local oscillator signals generated by the two phase-locked loops are the same, but it is quite difficult for the two phase-locked loops to maintain the same phase. A phase error between the local oscillator signals of the two chips affects a relative phase relationship between carrier frequencies of respective antenna transmit signals corresponding to the two chips, and further affects beamforming performance of a multi-antenna system.

Therefore, in the multi-antenna system, a problem needs to be urgently resolved: how to ensure that local oscillator signals output by a plurality of PLLs have a same phase when the plurality of PLLs are used to respectively provide the local oscillator signals for all radio frequency transceivers in a multi-chip combination solution.

### SUMMARY

Embodiments of this application provide a phase synchronization apparatus, a phase synchronization system, and a transceiver apparatus, to provide local oscillator signals with a same phase for each radio frequency transceiver chip in a multi-chip combination solution.

According to a first aspect, an embodiment of this application provides a phase synchronization system, including a first radio frequency transceiver chip and a second radio frequency transceiver chip. The first radio frequency transceiver chip includes a first phase-locked loop and a first control circuit, and the second radio frequency transceiver chip includes a second phase-locked loop. The first phase-locked loop is configured to generate a first local oscillator signal, and the second phase-locked loop is configured to generate a second local oscillator signal. The first control circuit is configured to: perform phase detection based on the first local oscillator signal and the second local oscillator signal to obtain a first phase error, generate a first control signal based on the first phase error, and perform phase control on the first phase-locked loop or the second phase-locked loop by using the first control signal.

According to the phase synchronization system provided in the first aspect, the first control circuit performs phase detection based on the first local oscillator signal and the second local oscillator signal to obtain the first phase error, generates the first control signal based on the first phase error, and performs phase control on the first phase-locked loop or the second phase-locked loop by using the first control signal. The first phase error may reflect a relative phase relationship between the first local oscillator signal and the second local oscillator signal. An architecture of such a feedback control system is constructed, so that local oscillator signals output by a first phase controller and a second phase controller have a same phase. In other words, it can be seen that a value of the first phase error tends to be zero at an output end of a first phase detector. Because the first phase-locked loop is placed on the first radio frequency transceiver chip, and the second phase-locked loop is placed on the second radio frequency transceiver chip, phase synchronization between the local oscillator signals of the two radio frequency transceiver chips may be implemented according to the phase synchronization system provided in the first aspect. Specifically, when the first control signal is generated based on the first phase error and is used to control the first phase-locked loop, a phase of the first local oscillator signal generated by the first phase-locked loop may be the same as a phase of the second local oscillator signal generated by the second phase-locked loop. Alternatively, when the first control signal is generated based on the first phase error and is used to control the second phase-locked loop, the phase of the second local oscillator signal generated by the second phase-locked loop may be the same as the phase of the first local oscillator signal generated by the first phase-locked loop.

Specifically, the first control circuit may include the first phase detector, configured to perform detection based on the first local oscillator signal and the second local oscillator signal to obtain the first phase error.

Specifically, the first control circuit may include the first phase controller, configured to generate the first control signal based on the first phase error. The first control signal is used to control a frequency division control word of the first phase-locked loop or the second phase-locked loop.

In a possible design, the first phase-locked loop is specifically configured to generate the first local oscillator signal based on a first reference clock signal. The second phase-locked loop is specifically configured to generate the second local oscillator signal based on the first reference clock signal.

According to the foregoing solution, the first phase-locked loop and the second phase-locked loop generate the local oscillator signals based on the same reference clock signal. In this case, the first local oscillator signal and the second local oscillator signal have a same phase. In this case, the first local oscillator signal and the second local oscillator signal are local oscillator signals whose frequencies and phases are the same.

In the phase synchronization system provided in the first aspect, the first phase-locked loop may generate the first local oscillator signal based on a direction of a control signal in the system in different implementations.

Implementation 1:

In the implementation 1, the first control circuit performs phase control on the first phase-locked loop by using the first control signal. In this case, when generating the first local oscillator signal, the first phase-locked loop is controlled by the first control signal to generate the first local oscillator signal based on the first reference clock signal.

Specifically, the first phase-locked loop may generate the first local oscillator signal in the following manner: The first phase-locked loop generates a frequency division control word based on the first control signal, and generates the first local oscillator signal based on the first reference clock signal and the frequency division control word.

According to the foregoing solution, the first control signal may change the frequency division control word of the first phase-locked loop, to change the phase of the first local oscillator signal generated by the first phase-locked loop.

Implementation 2:

In the implementation 2, the first control circuit performs phase control on the second phase-locked loop by using the first control signal. In this case, when generating the second local oscillator signal, the second phase-locked loop may be controlled by the first control signal to generate the second local oscillator signal based on the first reference clock signal.

In this way, the phase synchronization system provided in the first aspect further includes a third radio frequency transceiver chip. The third radio frequency transceiver chip includes a third phase-locked loop and a second control circuit. The third phase-locked loop is configured to generate a third local oscillator signal. The second control circuit is configured to: perform detection based on the third local oscillator signal and the first local oscillator signal to obtain a second phase error, and generate a second control signal based on the second phase error. When generating the first local oscillator signal, the first phase-locked loop may be controlled by the second control signal to generate the first local oscillator signal based on the first reference clock signal.

In other words, the first control signal generated by the first control circuit is output to the second phase-locked loop, and is used for phase control on the second phase-locked loop. In this case, for the first phase-locked loop, the phase synchronization system provided in the first aspect may further include a third radio frequency transceiver chip, to generate a control signal for performing phase control on the first phase-locked loop. Specifically, the third radio frequency transceiver chip includes a third phase-locked loop and a second control circuit.

Specifically, in the implementation 2, the first phase-locked loop may generate the first local oscillator signal in the following manner: The first phase-locked loop generates a frequency division control word based on the second control signal, and generates the first local oscillator signal based on the first reference clock signal and the frequency division control word.

According to the foregoing solution, the second control signal may change the frequency division control word of the first phase-locked loop, to change the phase of the first local oscillator signal generated by the first phase-locked loop.

Implementation 3:

In the implementation 3, when generating the first local oscillator signal, the first phase-locked loop generates the first local oscillator signal based on the first reference clock signal.

According to the foregoing solution, the first phase-locked loop may be used as a reference for calibration of another phase-locked loop, and the first phase-locked loop does not need to generate the local oscillator signal based on the control signal

In a possible design, the first phase-locked loop includes: a third phase detector, configured to detect a phase error between the first reference clock signal and a feedback clock signal; a loop controller, coupled to the third phase detector, and configured to generate a third control signal based on the phase error between the first reference clock signal and the feedback clock signal; a controlled oscillator, coupled to the loop controller, and configured to generate the first local oscillator signal based on the third control signal; a modulator, configured to generate a frequency division control word based on the first control signal or the second control signal, and a frequency control word; and a third frequency divider, coupled to the controlled oscillator and the modulator, and configured to: generate the feedback clock signal based on the first local oscillator signal and the frequency division control word, and output the feedback clock signal to the third phase detector.

In a conventional technology, a modulator in a phase-locked loop generates a frequency division control word based on a frequency control word. In the phase synchronization system provided in the first aspect, the first phase-locked loop further needs to generate the frequency division control word based on the control signal. Specifically, a logic circuit may be added to the phase-locked loop provided in the conventional technology to form the first phase-locked loop, so as to implement this function. A behavior of the modulator is intervened by using a control signal, to implement a phase adjustment function of a local oscillator signal output by the first phase-locked loop.

In a possible design, the first control circuit includes a first driver, configured to: receive the first local oscillator signal, and output the driven first local oscillator signal to the second control circuit.

Further, the first control circuit may further include a first buffer, configured to buffer the second local oscillator signal.

According to the foregoing solution, for local oscillator signals transmitted between chips, a buffer may buffer a local oscillator signal transmitted to the chip by another chip, and phase detection is further performed on a local oscillator signal output by a phase-locked loop in the chip and the local oscillator signal transmitted by the another chip to the chip. Similarly, when the local oscillator signal output by the phase-locked loop in the chip is output to the another chip for phase detection, the local oscillator signal output by the phase-locked loop in the chip may be output to the another chip by using a driver. The driver can be coupled to a buffer in the another chip to implement transmission of local oscillator signals.

In the phase synchronization system provided in the first aspect, transmission of local oscillator signals between chips may be implemented by using a driver and a buffer. However, during transmission of the local oscillator signals between the chips, a delay on a transmission path causes a phase change of the local oscillator signals.

To reduce a phase error introduced on the transmission path, in a possible design, the first control circuit includes a second phase detector, configured to perform detection based on the third local oscillator signal and the first local oscillator signal to obtain a third phase error. The second control circuit generates the second control signal based on a difference between the second phase error and the third phase error.

When the first control circuit includes the second phase detector, the second phase detector similarly performs detection based on the first local oscillator signal and the third local oscillator signal generated by the third phase-locked loop, to obtain the second phase error. The first phase-locked loop and the first control circuit are integrated into the first radio frequency transceiver chip, and the second control circuit and the third phase-locked loop are integrated into the third radio frequency transceiver chip. Therefore, when the second control circuit detects the second phase error, the second phase error is detected after the first local oscillator signal is transmitted from the first radio frequency transceiver chip to the third radio frequency transceiver chip. The second phase error includes a phase error caused on a transmission path from the first radio frequency transceiver chip to the third radio frequency transceiver chip. When the second phase detector detects the third phase error, the third phase error is detected after the third local oscillator signal is transmitted from the third radio frequency transceiver chip to the first radio frequency transceiver chip. The third phase error includes a phase error caused on a transmission path from the third radio frequency transceiver chip to the first radio frequency transceiver chip. Therefore, when the second control circuit generates the second control signal based on a difference between the second phase error and the third phase error, the difference between the second phase error and the third phase error can offset the phase error caused on a transmission path.

In a possible design, the second radio frequency transceiver chip further includes a third control circuit, configured to perform detection based on the first local oscillator signal and the second local oscillator signal to obtain a fourth phase error. When generating the first control signal, the first control circuit is specifically configured to generate the first control signal based on a difference between the first phase error and the fourth phase error.

According to the foregoing solution, the third control circuit coupled to the second phase-locked loop may also perform phase detection based on the first local oscillator signal and the second local oscillator signal to obtain the fourth phase error, and transmit the fourth phase error to the first control circuit. When generating the first control signal, the first control circuit may generate the first control signal based on the difference between the first phase error and the fourth phase error.

The first phase-locked loop and the first control circuit are integrated into the first radio frequency transceiver chip, and the second phase-locked loop and the third control circuit are integrated into the second radio frequency transceiver chip. Therefore, when the first control circuit detects the first phase error, the first phase error is detected after the second local oscillator signal is transmitted from the second radio frequency transceiver chip to the first radio frequency transceiver chip. The first phase error includes a phase error caused on a transmission path from the second radio frequency transceiver chip to the first radio frequency transceiver chip. When the third control circuit detects the fourth phase error, the fourth phase error is detected after the first local oscillator signal is transmitted from the first radio frequency transceiver chip to the second radio frequency transceiver chip. The fourth phase error includes a phase error caused on a transmission path from the first radio frequency transceiver chip to the second radio frequency transceiver chip. Therefore, when the first control circuit generates the first control signal based on the difference between the first phase error and the fourth phase error, the difference between the first phase error and the fourth phase error can offset a phase error caused on a transmission path.

In a possible design, the first control circuit may include a second driver, configured to: receive the first local oscillator signal, and output the driven first local oscillator signal to the third control circuit. Similarly, the first control circuit may further include a second buffer, configured to buffer the third local oscillator signal.

According to the foregoing solution, during transmission of each local oscillator signal between chips, the local oscillator signal passes through both a driver and a buffer on a transmission path. When drivers and buffers in the system have same specifications, it may be considered that phase errors caused during transmission of the local oscillator signals between the chips are approximately the same. Therefore, when a control signal is generated based on a difference between two phase errors (for example, the first control circuit generates the first control signal based on the difference between the first phase error and the fourth phase error), a phase error caused on the transmission path can be offset.

In the phase synchronization system provided in the first aspect, the first control circuit performs phase detection based on the first local oscillator signal and the second local oscillator signal to obtain the first phase error. The first phase error may reflect a relative phase relationship between the first local oscillator signal and the second local oscillator signal. During specific implementation, the first phase error may have a plurality of meanings.

First meaning: The first phase error is a phase error between the first local oscillator signal and the second local oscillator signal.

In this case, the first phase detector may specifically perform detection in the following manner based on the first local oscillator signal and the second local oscillator signal to obtain the first phase error: The first phase detector detects a phase error between the first local oscillator signal and the second local oscillator signal, to obtain the first phase error.

In a first manner, the first phase detector directly detects the phase error between the first local oscillator signal and the second local oscillator signal, may generate the first control signal based on the phase error between the first local oscillator signal and the second local oscillator signal, and is configured to perform phase control on the first phase-locked loop or the second phase-locked loop.

Second meaning: The first phase error is a phase error between the frequency-divided first local oscillator signal and the frequency-divided second local oscillator signal.

In a second manner, the first control circuit further includes a first frequency divider, coupled to the first phase-locked loop, and configured to perform frequency division on the first local oscillator signal. The third control circuit further includes a second frequency divider, coupled to the second phase-locked loop, and configured to perform frequency division on the second local oscillator signal. A frequency division ratio of the second frequency divider is the same as that of the first frequency divider. When performing detection based on the first local oscillator signal and the second local oscillator signal to obtain the first phase error, the first control circuit is specifically configured to detect a phase error between the first local oscillator signal obtained by performing frequency division by the first frequency divider and the second local oscillator signal obtained by performing frequency division by the second frequency divider, to obtain the first phase error.

In the second manner, after frequency division processing is performed on a local oscillator signal, subsequent phase detection and signal transmission both are performed at a low frequency. Compared with that in the foregoing first manner, a power consumption level in the second manner is significantly reduced.

In a possible design, if the first control signal is output to the second phase-locked loop, the first radio frequency transceiver chip further includes a first digital interface, and the second radio frequency transceiver chip further includes a second digital interface. The phase synchronization system provided in the first aspect further includes a control chip. The first digital interface is coupled to the first control circuit, and is configured to receive and output the first control signal. The control chip is coupled to the first digital interface and the second digital interface, and is configured to transmit, to the second digital interface, the first control signal output by the first digital interface. The second digital interface is coupled to the second phase-locked loop.

The first digital interface and the second digital interface may be universal digital interfaces. The universal digital interface may be used as a common interface for signal transmission between chips. A digital interface module of this type is usually provided on a radio frequency transceiver chip, and is used as a universal interface for an upper-layer system to deliver an instruction to the radio frequency transceiver chip, or for an upper-layer system to collect status information from the radio frequency transceiver chip. In this embodiment of this application, this interface may be directly reused for information transmission between the chips, and resources such as a hardware pin do not need to be added.

The control chip may be a master control chip in the system. The master control chip bears software and hardware functions of the upper-layer system, and communicates with the radio frequency transceiver chips through the universal digital interfaces in a form of instructions or data. In this embodiment of this application, the master control chip may be directly reused for information transmission between the chips.

According to the foregoing solution, the existing chips and interfaces may be reused for information transmission between chips, to implement phase synchronization between local oscillator signals.

In a possible design, the first radio frequency transceiver chip further includes: a fourth phase-locked loop, configured to generate a fourth local oscillator signal; and a fourth control circuit, configured to: perform detection based on the fourth local oscillator signal and the first local oscillator signal to obtain a fifth phase error, generate a fourth control signal based on the fifth phase error, and perform phase control on the first phase-locked loop or the fourth phase-locked loop by using the fourth control signal.

The first phase-locked loop may be configured to provide a local oscillator signal for a part of radio frequency channels in the first radio frequency transceiver chip, and the fourth phase-locked loop may be configured to provide a local oscillator signal for another part of radio frequency channels in the first radio frequency transceiver chip. According to the foregoing solution, the first phase-locked loop and the fourth phase-locked loop in the first radio frequency transceiver chip may output local oscillator signals with a same phase. In this way, local oscillator signals with a same phase are provided for all radio frequency channels in the first radio frequency transceiver chip.

In a possible design, the first radio frequency transceiver chip further includes a plurality of first transmission channels. The first phase-locked loop is specifically configured to provide the first local oscillator signal for the plurality of first transmission channels. The second radio frequency transceiver chip further includes a plurality of second transmission channels, and the second phase-locked loop is specifically configured to provide the second local oscillator signal for the plurality of second transmission channels. The plurality of first transmission channels and the plurality of second transmission channels are used to support multiple-input multiple-output (MIMO) transmission.

During specific implementation, the plurality of first transmission channels in the first radio frequency transceiver chip are respectively coupled to a plurality of first antennas, and the plurality of second transmission channels in the second radio frequency transceiver chip are respectively coupled to a plurality of second antennas. The plurality of first antennas and the plurality of second antennas form a MIMO antenna array. The plurality of first transmission channels and the plurality of second transmission channels all are configured to send signals of a same carrier frequency, or the plurality of first transmission channels and the plurality of second transmission channels all are configured to receive signals of a same carrier frequency.

The signals transmitted through the first transmission channels and the second transmission channels may be 5G NR signals.

In a possible design, the first radio frequency transceiver chip further includes a plurality of first transmission channels, and the first phase-locked loop is specifically configured to provide the first local oscillator signal for the plurality of first transmission channels. The second radio frequency transceiver chip further includes a plurality of second transmission channels, and the second phase-locked loop is specifically configured to provide the second local oscillator signal for the plurality of second transmission channels. The plurality of first transmission channels and the plurality of second transmission channels are used to support phased array transmission.

During specific implementation, the plurality of first transmission channels in the first radio frequency transceiver chip are respectively coupled to a plurality of first antennas, and the plurality of second transmission channels in the second radio frequency transceiver chip are respectively coupled to a plurality of second antennas. The plurality of first antennas and the plurality of second antennas form a phased array antenna array. A plurality of signals respectively transmitted through the plurality of first transmission channels and a plurality of signals respectively transmitted through the plurality of second transmission channels are used for beamforming.

The signals transmitted through the first transmission channels and the second transmission channels may be 5G NR signals.

According to a second aspect, an embodiment of this application provides a phase synchronization apparatus. The phase synchronization apparatus includes a first phase-locked loop and a first control circuit that are integrated into a first radio frequency transceiver chip. The first phase-locked loop is configured to generate a first local oscillator signal. The first control circuit is configured to: perform detection based on the first local oscillator signal and a second local oscillator signal generated by a second phase-locked loop in a second radio frequency transceiver chip, to obtain a first phase error; generate a first control signal based on the first phase error; and perform phase control on the first phase-locked loop or the second phase-locked loop by using the first control signal.

According to the phase synchronization apparatus provided in the second aspect, the first control circuit performs phase detection based on the first local oscillator signal and the second local oscillator signal to obtain the first phase error, generates the first control signal based on the first phase error, and performs phase control on the first phase-locked loop or the second phase-locked loop by using the first control signal. The first phase error may reflect a relative phase relationship between the first local oscillator signal and the second local oscillator signal. An architecture of such a feedback control system is constructed, so that local oscillator signals output by a first phase controller and a second phase controller have a same phase. In other words, it can be seen that a value of the first phase error tends to be zero at an output end of a first phase detector. Because the first phase-locked loop is placed on the first radio frequency transceiver chip, and the second phase-locked loop is placed on the second radio frequency transceiver chip, phase synchronization between the local oscillator signals of two radio frequency transceiver chips may be implemented according to the phase synchronization apparatus provided in the second aspect. Specifically, when the first control signal is generated based on the first phase error and is used to control the first phase-locked loop, a phase of the first local oscillator signal generated by the first phase-locked loop may be the same as a phase of the second local oscillator signal generated by the second phase-locked loop. Alternatively, when the first control signal is generated based on the first phase error and is used to control the second phase-locked loop, the phase of the second local oscillator signal generated by the second phase-locked loop may be the same as the phase of the first local oscillator signal generated by the first phase-locked loop.

It should be noted that the phase synchronization apparatus provided in the second aspect may be understood as a phase-locked loop and a control circuit that are integrated into a radio frequency transceiver chip, or understood as a radio frequency transceiver chip. Operation principles and processing logic of the phase-locked loop and the control circuit in the phase synchronization apparatus are the same as those of the phase-locked loop and the control circuit provided in the first aspect.

Specifically, the first control circuit may include the first phase detector, configured to perform detection based on the first local oscillator signal and the second local oscillator signal to obtain the first phase error.

Specifically, the first control circuit may include the first phase controller, configured to generate the first control signal based on the first phase error. The first control signal is used to control a frequency division control word of the first phase-locked loop or the second phase-locked loop.

The first phase controller is any one of a proportional controller, an integral controller, or a proportional-integral controller.

In other words, an operation of detecting the first phase error and an operation of generating the first control signal may be respectively performed by the first phase detector and the first phase controller in the phase synchronization apparatus provided in the second aspect.

Optionally, the first phase-locked loop is specifically configured to generate the first local oscillator signal based on a first reference clock signal. The first reference clock signal is a reference clock signal based on which the second phase-locked loop generates the second local oscillator signal

According to the foregoing solution, the first phase-locked loop and the second phase-locked loop generate local oscillator signals based on the same reference clock signal. In this case, the first local oscillator signal and the second local oscillator signal have a same phase. In this case, the first local oscillator signal and the second local oscillator signal are local oscillator signals whose frequencies and phases are the same.

Optionally, the first phase-locked loop is specifically configured to be controlled by the first control signal to generate the first local oscillator signal based on the first reference clock signal.

According to the foregoing solution, the first control signal may change the frequency division control word of the first phase-locked loop, to change the phase of the first local oscillator signal generated by the first phase-locked loop.

Optionally, the first phase-locked loop is specifically configured to be controlled by a second control signal to generate the first local oscillator signal based on the first reference clock signal. The second control signal is a control signal generated by a second control circuit in a third radio frequency transceiver chip. The second control circuit is configured to: perform detection based on the first local oscillator signal and a third local oscillator signal generated by a third phase-locked loop in the third radio frequency transceiver chip, to obtain a second phase error; and generate the second control signal based on the second phase error.

According to the foregoing solution, the first control signal generated by the first control circuit is output to the second phase-locked loop, and is used for phase control on the second phase-locked loop. In addition, the third radio frequency transceiver chip includes the third phase-locked loop and the second control circuit. In this case, for the first phase-locked loop, the second control signal generated by the third radio frequency transceiver chip may be used for phase control on the first phase-locked loop. Specifically, the second control signal may change the frequency division control word of the first phase-locked loop, to change the phase of the first local oscillator signal generated by the first phase-locked loop.

Further, the first control circuit includes a first driver, configured to: receive the first local oscillator signal, and output the driven first local oscillator signal to the second control circuit.

Correspondingly, the first control circuit further includes a first buffer, configured to buffer the second local oscillator signal.

According to the foregoing solution, for local oscillator signals transmitted between chips, a buffer may buffer a local oscillator signal transmitted to the chip by another chip, and phase detection is further performed on a local oscillator signal output by a phase-locked loop in the chip and the local oscillator signal transmitted by the another chip to the chip. Similarly, when the local oscillator signal output by the phase-locked loop in the chip is output to the another chip for phase detection, the local oscillator signal output by the phase-locked loop in the chip may be output to the another chip by using a driver. The driver can be coupled to a buffer in the another chip to implement transmission of local oscillator signals.

In a possible implementation, the first control circuit includes a second phase detector, configured to perform detection based on the third local oscillator signal and the first local oscillator signal to obtain a third phase error. The third phase error is used for the second control circuit to generate the second control signal based on a difference between the second phase error and the third phase error.

When the first control circuit includes the second phase detector, the second phase detector similarly performs detection based on the first local oscillator signal and the third local oscillator signal generated by the third phase-locked loop, to obtain the second phase error. The first phase-locked loop and the first control circuit are integrated into the first radio frequency transceiver chip, and the second control circuit and the third phase-locked loop are integrated into the third radio frequency transceiver chip. Therefore, when the second control circuit detects the second phase error, the second phase error is detected after the first local oscillator signal is transmitted from the first radio frequency transceiver chip to the third radio frequency transceiver chip. The second phase error includes a phase error caused on a transmission path from the first radio frequency transceiver chip to the third radio frequency transceiver chip. When the second phase detector detects the third phase error, the third phase error is detected after the third local oscillator signal is transmitted from the third radio frequency transceiver chip to the first radio frequency transceiver chip. The third phase error includes a phase error caused on a transmission path from the third radio frequency transceiver chip to the first radio frequency transceiver chip. Therefore, when the second control circuit generates the second control signal based on a difference between the second phase error and the third phase error, the difference between the second phase error and the third phase error can offset the phase error caused on a transmission path.

Similarly, the first control circuit may generate the first control signal based on the first phase error in the following manner: The first control circuit generates the first control signal based on a difference between the first phase error and a fourth phase error. A third control circuit coupled to the second phase-locked loop in the second radio frequency transceiver chip performs detection based on the first local oscillator signal and the second local oscillator signal to obtain the fourth phase error.

According to the foregoing solution, the third control circuit coupled to the second phase-locked loop may also perform phase detection based on the first local oscillator signal and the second local oscillator signal to obtain the fourth phase error, and transmit the fourth phase error to the first control circuit. When generating the first control signal, the first control circuit may generate the first control signal based on the difference between the first phase error and the fourth phase error.

The first phase-locked loop and the first control circuit are integrated into the first radio frequency transceiver chip, and the second phase-locked loop and the third control circuit are integrated into the second radio frequency transceiver chip. Therefore, when the first control circuit detects the first phase error, the first phase error is detected after the second local oscillator signal is transmitted from the second radio frequency transceiver chip to the first radio frequency transceiver chip. The first phase error includes a phase error caused on a transmission path from the second radio frequency transceiver chip to the first radio frequency transceiver chip. When the third control circuit detects the fourth phase error, the fourth phase error is detected after the first local oscillator signal is transmitted from the first radio frequency transceiver chip to the second radio frequency transceiver chip. The fourth phase error includes a phase error caused on a transmission path from the first radio frequency transceiver chip to the second radio frequency transceiver chip. In this way, when the first control circuit generates the first control signal based on the difference between the first phase error and the fourth phase error, the difference between the first phase error and the fourth phase error can offset a phase error caused on a transmission path.

In addition, the first control circuit includes a second driver, configured to: receive the first local oscillator signal, and output the driven first local oscillator signal to the third control circuit. The first control circuit further includes a second buffer, configured to buffer the third local oscillator signal.

According to the foregoing solution, during transmission of each local oscillator signal between chips, the local oscillator signal passes through both a driver and a buffer on a transmission path. When drivers and buffers in the system have same specifications, it may be considered that phase errors caused during transmission of the local oscillator signals between the chips are approximately the same. Therefore, when a control signal is generated based on a difference between two phase errors (for example, the first control circuit generates the first control signal based on the difference between the first phase error and the fourth phase error), a phase error caused on the transmission path can be offset.

In a first implementation, the first control circuit may perform detection in the following manner based on the first local oscillator signal and the second local oscillator signal to obtain the first phase error: The first control circuit detects a phase error between the first local oscillator signal and the second local oscillator signal, to obtain the first phase error.

According to the first implementation, the first phase detector directly detects the phase error between the first local oscillator signal and the second local oscillator signal, may generate the first control signal based on the phase error between the first local oscillator signal and the second local oscillator signal, and is configured to perform phase control on the first phase-locked loop or the second phase-locked loop.

In a second implementation, the first control circuit further includes a first frequency divider, coupled to the first phase-locked loop, and configured to perform frequency division on the first local oscillator signal. In this case, when performing detection based on the first local oscillator signal and the second local oscillator signal to obtain the first phase error, the first control circuit is specifically configured to detect a phase error between the first local oscillator signal obtained by performing frequency division by the first frequency divider and the second local oscillator signal obtained by performing frequency division by a second frequency divider in the third control circuit, to obtain the first phase error. A frequency division ratio of the second frequency divider is the same as that of the first frequency divider.

In the second implementation, after frequency division processing is performed on a local oscillator signal, subsequent phase detection and signal transmission both are performed at a low frequency. Compared with that in the foregoing first implementation, a power consumption level in the second manner is significantly reduced.

In addition, the first phase-locked loop may include: a third phase detector, configured to detect a phase error between the first reference clock signal and a feedback clock signal; a loop controller, coupled to the third phase detector, and configured to generate a third control signal based on the phase error between the first reference clock signal and the feedback clock signal; a controlled oscillator, coupled to the loop controller, and configured to generate the first local oscillator signal based on the third control signal; a modulator, configured to generate a frequency division control word based on the first control signal or the second control signal, and a frequency control word; and a third frequency divider, coupled to the controlled oscillator and the modulator, and configured to: generate the feedback clock signal based on the first local oscillator signal and the frequency division control word, and output the feedback clock signal to the third phase detector.

According to the foregoing solution, a specific structure of the first phase-locked loop is provided. The same structure may also be used for another phase-locked loop in the phase synchronization apparatus provided in the second aspect. Details are not described herein again.

To implement signal transmission between chips, the phase synchronization apparatus provided in the second aspect further includes a first digital interface. The first digital interface is coupled to the first control circuit, and is configured to receive the first control signal and output the first control signal to a control chip. The control chip is coupled to the first digital interface and a second digital interface in the second radio frequency transceiver chip, and is configured to transmit, to the second digital interface, the first control signal output by the first digital interface. The second digital interface is coupled to the second phase-locked loop.

According to the foregoing solution, the existing chips and interfaces may be reused for information transmission between chips, to implement phase synchronization between local oscillator signals.

In addition, when one radio frequency transceiver chip includes a large number of radio frequency channels, the first radio frequency transceiver chip further includes: a fourth phase-locked loop, configured to generate a fourth local oscillator signal; and a fourth control circuit, configured to: perform detection based on the fourth local oscillator signal and the first local oscillator signal to obtain a fifth phase error, generate a fourth control signal based on the fifth phase error, and perform phase control on the first phase-locked loop or the fourth phase-locked loop by using the fourth control signal.

The first phase-locked loop may be configured to provide a local oscillator signal for a part of radio frequency channels in the first radio frequency transceiver chip, and the fourth phase-locked loop may be configured to provide a local oscillator signal for another part of radio frequency channels in the first radio frequency transceiver chip.

According to the foregoing solution, the first phase-locked loop may be configured to provide the local oscillator signal for a part of radio frequency channels in the first radio frequency transceiver chip, and the fourth phase-locked loop may be configured to provide the local oscillator signal for the another part of radio frequency channels in the first radio frequency transceiver chip. In this way, the first phase-locked loop and the fourth phase-locked loop in the first radio frequency transceiver chip may output local oscillator signals with a same phase. In this way, local oscillator signals with a same phase are provided for all radio frequency channels in the first radio frequency transceiver chip.

In a possible design, the first radio frequency transceiver chip further includes a plurality of first transmission channels, and the first phase-locked loop is specifically configured to provide the first local oscillator signal for the plurality of first transmission channels. The second radio frequency transceiver chip further includes a plurality of second transmission channels, and the second phase-locked loop is specifically configured to provide the second local oscillator signal for the plurality of second transmission channels. The plurality of first transmission channels and the plurality of second transmission channels are used to support MIMO transmission.

During specific implementation, the plurality of first transmission channels in the first radio frequency transceiver chip are respectively coupled to a plurality of first antennas, and the plurality of second transmission channels in the second radio frequency transceiver chip are respectively coupled to a plurality of second antennas. The plurality of first antennas and the plurality of second antennas form a MIMO antenna array. The plurality of first transmission channels and the plurality of second transmission channels all are configured to send signals of a same carrier frequency, or the plurality of first transmission channels and the plurality of second transmission channels all are configured to receive signals of a same carrier frequency.

The signals transmitted through the first transmission channels and the second transmission channels may be 5G NR signals.

In a possible design, the first radio frequency transceiver chip further includes a plurality of first transmission channels, and the first phase-locked loop is specifically configured to provide the first local oscillator signal for the plurality of first transmission channels. The second radio frequency transceiver chip further includes a plurality of second transmission channels, and the second phase-locked loop is specifically configured to provide the second local oscillator signal for the plurality of second transmission channels. The plurality of first transmission channels and the plurality of second transmission channels are used to support phased array transmission.

During specific implementation, the plurality of first transmission channels in the first radio frequency transceiver chip are respectively coupled to a plurality of first antennas, and the plurality of second transmission channels in the second radio frequency transceiver chip are respectively coupled to a plurality of second antennas. The plurality of first antennas and the plurality of second antennas form a phased array antenna array. A plurality of signals respectively transmitted through the plurality of first transmission channels and a plurality of signals respectively transmitted through the plurality of second transmission channels are used for beamforming.

The signals transmitted through the first transmission channels and the second transmission channels may be 5G NR signals.

According to a third aspect, an embodiment of this application provides a transceiver apparatus. The transceiver includes the first radio frequency transceiver chip and the second radio frequency transceiver chip that are provided in any one of the first aspect and the possible designs of the first aspect. The first radio frequency transceiver chip further includes a plurality of first transmission channels, and a first phase-locked loop in the first radio frequency transceiver chip is specifically configured to provide a first local oscillator signal for the plurality of first transmission channels. The second radio frequency transceiver chip further includes a plurality of second transmission channels, and a second phase-locked loop in the second radio frequency transceiver chip is specifically configured to provide a second local oscillator signal for the plurality of second transmission channels. The plurality of first transmission channels and the plurality of second transmission channels are used to support MIMO transmission.

Specifically, the plurality of first transmission channels in the first radio frequency transceiver chip are respectively coupled to a plurality of first antennas, and the plurality of second transmission channels in the second radio frequency transceiver chip are respectively coupled to a plurality of second antennas. The plurality of first antennas and the plurality of second antennas form a MIMO antenna array. The plurality of first transmission channels and the plurality of second transmission channels all are configured to send signals of a same carrier frequency, or the plurality of first transmission channels and the plurality of second transmission channels all are configured to receive signals of a same carrier frequency.

The signals transmitted through the first transmission channels and the second transmission channels may be 5G NR signals.

According to a fourth aspect, an embodiment of this application provides a transceiver apparatus. The transceiver includes the first radio frequency transceiver chip and the second radio frequency transceiver chip that are provided in any one of the first aspect and the possible designs of the first aspect. The first radio frequency transceiver chip further includes a plurality of first transmission channels, and a first phase-locked loop in the first radio frequency transceiver chip is specifically configured to provide a first local oscillator signal for the plurality of first transmission channels. The second radio frequency transceiver chip further includes a plurality of second transmission channels, and a second phase-locked loop in the second radio frequency transceiver chip is specifically configured to provide a second local oscillator signal for the plurality of second transmission channels. The plurality of first transmission channels and the plurality of second transmission channels are used to support phased array transmission.

Specifically, the plurality of first transmission channels in the first radio frequency transceiver chip are respectively coupled to a plurality of first antennas, and the plurality of second transmission channels in the second radio frequency transceiver chip are respectively coupled to a plurality of second antennas. The plurality of first antennas and the plurality of second antennas form a phased array antenna array. A plurality of signals respectively transmitted through the plurality of first transmission channels and a plurality of signals respectively transmitted through the plurality of second transmission channels are used for beamforming.

The signals transmitted through the first transmission channels and the second transmission channels may be 5G NR signals.

According to a fifth aspect, an embodiment of this application provides a phase synchronization system. The phase synchronization system includes N phase-locked loops and N control circuits respectively corresponding to the N phase-locked loops, where N > 1. An $i^{th}$ phase-locked loop in the N phase-locked loops is configured to generate a first local oscillator signal, and $1 \leq i < N$. A control circuit corresponding to the $i^{th}$ phase-locked loop is configured to: perform phase detection based on the first local oscillator signal and a second local oscillator signal generated by an $(i + 1)^{th}$ phase-locked loop to obtain a first phase error, generate a first control signal based on the first phase error, and perform phase control on the $(i + 1)^{th}$ phase-locked loop by using the first control signal.

According to a sixth aspect, an embodiment of this application provides a phase synchronization system. The phase synchronization system includes N phase-locked loops and N control circuits respectively corresponding to the N phase-locked loops, where N > 1. An $i^{th}$ phase-locked loop in the N phase-locked loops is configured to generate a first local oscillator signal, and $1 \leq i < N$. A control circuit corresponding to the $i^{th}$ phase-locked loop is configured to: perform phase detection based on the first local oscillator signal and a second local oscillator signal generated by an $(i + 1)^{th}$ phase-locked loop to obtain a first phase error, generate a first control signal based on the first phase error, and perform phase control on the $i^{th}$ phase-locked loop by using the first control signal.

It should be noted that, for implementations and technical effects that are not described in detail in the phase synchronization apparatus provided in the second aspect or the phase synchronization system provided in the sixth aspect, refer to related descriptions in the phase synchronization system provided in the first aspect. Details are not described herein again.


**BRIEF DESCRIPTION OF DRAWINGS**

FIG. 1 is a schematic diagram of a structure of a radio frequency transceiver according to a conventional technology;
FIG. 2 is a schematic diagram of an implementation of antenna array expansion according to a conventional technology;
FIG. 3 is a schematic diagram of another implementation of antenna array expansion according to a conventional technology;
FIG. 4 is a schematic diagram of a structure of a radio frequency system supporting a multi-antenna technology according to a conventional technology;

FIG. 5 is a schematic diagram of a structure of a first radio frequency system according to an embodiment of this application;

FIG. 6A and FIG. 6B are a schematic diagram of a structure of a second radio frequency system according to an embodiment of this application;

FIG. 7 is a schematic diagram of a structure of a first phase synchronization system according to an embodiment of this application;

FIG. 8 is a schematic diagram of a structure of a second phase synchronization system according to an embodiment of this application;

FIG. 9 is a schematic diagram of a structure of a third phase synchronization system according to an embodiment of this application;

FIG. 10 is a schematic diagram of a structure of a first phase-locked loop according to an embodiment of this application;

FIG. 11 is a schematic diagram of a structure of another first phase-locked loop according to an embodiment of this application;

FIG. 12A and FIG. 12B are a schematic diagram of a structure of a fourth phase synchronization system according to an embodiment of this application;

FIG. 13A and FIG. 13B are a schematic diagram of a structure of a fifth phase synchronization system according to an embodiment of this application;

FIG. 14A and FIG. 14B are a schematic diagram of a structure of a sixth phase synchronization system according to an embodiment of this application;

FIG. 15A and FIG. 15B are a schematic diagram of a structure of a seventh phase synchronization system according to an embodiment of this application;

FIG. 16 is a schematic diagram of a structure of a phase synchronization apparatus according to an embodiment of this application; and

FIG. 17 is a schematic diagram of a structure of a transceiver apparatus according to an embodiment of this application.

## DESCRIPTION OF EMBODIMENTS

The following first describes application scenarios of the embodiments of this application.

The embodiments of this application may be applied to an application scenario in which a plurality of PLLs provide local oscillator signals for all radio frequency transceivers in a multi-chip combination solution, and the local oscillator signals need to have a same phase.

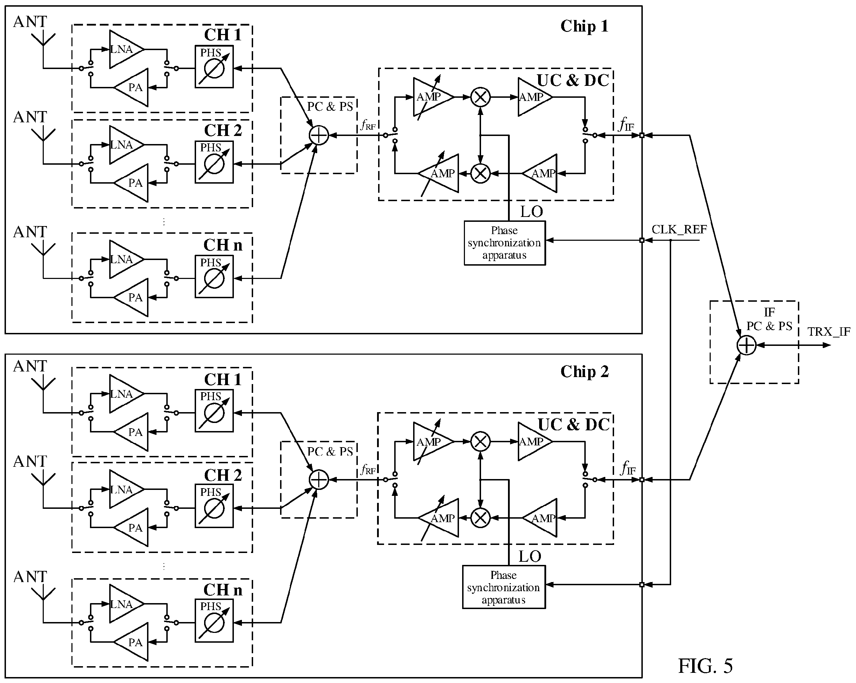

For example, the embodiments of this application may be applied to a radio frequency system shown in FIG. 5. The radio frequency system shown in FIG. 5 includes two radio frequency transceiver chips, and n radio frequency transceiver channels are integrated into each chip. Each radio frequency transceiver channel includes an LNA, a PA, and a PHS. A proper phase shift parameter is configured for a PHS of each transceiver channel, so that an equivalent antenna gain in a specific spatial direction can be improved by spatially combining signals received or transmitted by a plurality of antennas. In addition, each chip includes a UC/DC for up-conversion/down-conversion.

Specifically, in a receive direction, after a signal received by each ANT is amplified by an LNA, a phase shift operation is performed on the signal by a PHS. The phase-shifted received signals are combined into one signal by a PC. The signal obtained through combination is transferred to a lower carrier frequency by a DC for processing. In a transmit direction, baseband signals are frequency-converted into intermediate frequency signals, and then the intermediate frequency signals are sent to a chip. The intermediate frequency signals are frequency-converted by a UC for a second time and transferred to a radio frequency carrier frequency. Then, the signals are divided into n signals by a PS, and the n signals are respectively sent to n radio frequency transceiver channels. A PHS phase-shifts a signal sent to each radio frequency transceiver channel, and then a phase-shifted signal is sent by the PA to the ANT and are radiated to free space by the ANT.

In the radio frequency system shown in FIG. 5, a phase synchronization apparatus provided in the embodiments of this application provides a local oscillator signal for each of an up-conversion operation and a down-conversion operation on each chip, so that local oscillator signals with a same phase are used when the up-conversion operation and the down-conversion operation are performed on the chip. Therefore, the local oscillator signals do not affect a relative phase relationship between ANTs, and a phase of each radio frequency transceiver channel is adjusted only by a PHS. This can improve beamforming performance of the system.

It should be understood that the radio frequency system shown in FIG. 5 is merely an example. In another implementation, the radio frequency transceiver channel and the UC/DC may alternatively be integrated into two chips respectively. In this implementation, there is still an application scenario in which a plurality of PLLs provide local oscillator signals with a same phase for all radio frequency transceivers in the multi-chip combination solution. The embodiments of this application are also applicable to this application scenario.

It should be noted that, in the radio frequency system shown in FIG. 5, a superheterodyne structure is used as an example to describe a down-conversion operation, to be specific, a signal is first transferred from a radio frequency carrier frequency $f_{RF}$ to an intermediate frequency $f_{IF}$. An intermediate frequency signal that passes through the down-converter shown in FIG. 5 needs to be transferred to a baseband through another frequency conversion, and is converted into a digital signal by an ADC for further processing. In addition, the down-converter may alternatively be implemented based on a structure such as a zero intermediate frequency (ZIF) or a low intermediate frequency (LIF).

Similarly, in the radio frequency system shown in FIG. 5, a superheterodyne structure is used as an example to describe an up-conversion operation, to be specific, a baseband signal is transferred to a radio frequency carrier frequency $f_{RF}$ after two frequency conversion operations. An up-converter in FIG. 5 performs a second frequency conversion, to be specific, transfers an intermediate frequency signal to the radio frequency carrier frequency. In addition, the up-conversion operation may alternatively be implemented by using a zero intermediate frequency structure, to be specific, the baseband signal is directly transferred to the radio frequency carrier frequency through only one frequency conversion, or up-conversion is implemented based on a low intermediate frequency structure.

Specific manners of the up-conversion operation and the down-conversion operation do not affect solutions in the embodiments of this application, and may be implemented through an up-conversion operation and a down-conversion operation in a conventional technology. Therefore, the specific manners are not described in detail in the embodiments of this application.

In addition, an architecture shown in FIG. 5 includes an antenna corresponding to each transceiver channel. During actual application, the antenna may be disposed on a silicon wafer in a chip, a chip packaging structure, or a circuit board. This is not specifically limited in the embodiments of this application.

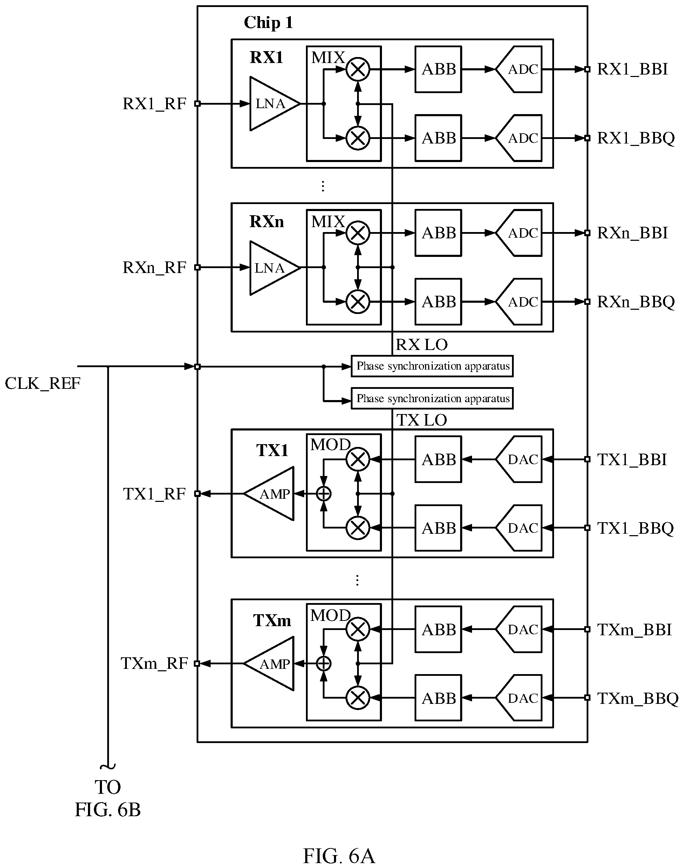

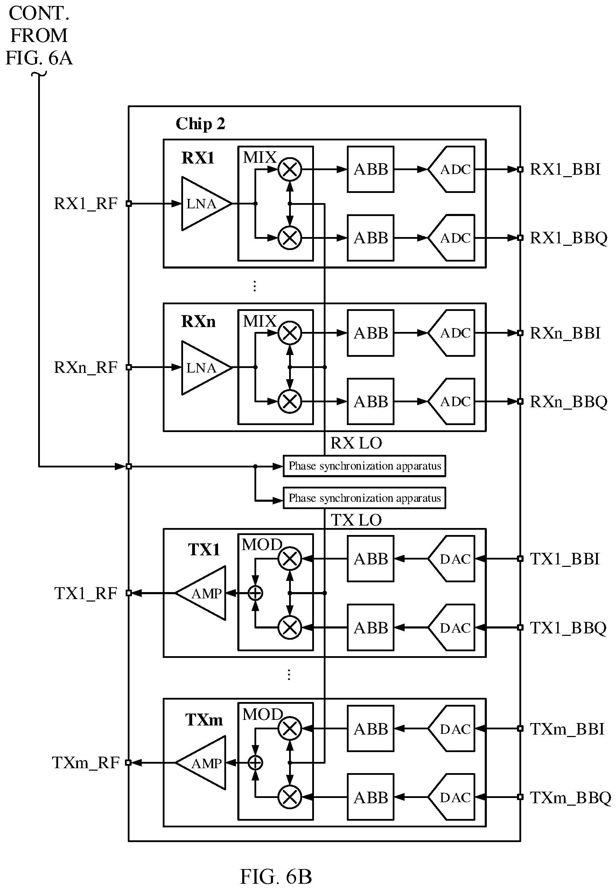

For example, the embodiments of this application may be applied to a radio frequency system shown in FIG. 6A and FIG. 6B. The radio frequency system shown in FIG. 6A and FIG. 6B includes two radio frequency transceiver chips: a chip 1 and a chip 2. n receive channels (RX1 to RXn) and m transmit channels (TX1 to TXm) are integrated into each chip. In this case, each chip can support operation of a multi-antenna system including n receive antennas and m transmit antennas. Each receive channel includes an LNA, a mixer (MIX), an analog baseband (ABB) processor, an analog-to-digital converter (ADC), and the like. Each transmit channel includes a digital-to-analog converter (DAC), an ABB, a modulator (MOD), a power amplifier (Amp), and the like.

In the radio frequency system shown in FIG. 6A and FIG. 6B, the phase synchronization apparatus provided in the embodiments of this application can provide local oscillator signals with a same phase for receive channels in the chips, so that a local oscillator signal of each receive channel does not affect a relative phase relationship between receive antennas. In addition, the phase synchronization apparatus provided in the embodiments of this application can provide local oscillator signals with a same phase for transmit channels in the chips, so that a local oscillator signal of each transmit channel does not affect a relative phase relationship between the transmit antennas.

It should be noted that, in a structure shown in FIG. 6A and FIG. 6B, a zero intermediate frequency (ZIF) structure is used for both the receive channel and the transmit channel, that is, conversion between a baseband signal and a radio frequency signal is implemented through one frequency conversion. During actual application, the up-conversion/down-conversion operation may alternatively be implemented through two frequency conversions. This is not specifically limited in this embodiment of this application.

Certainly, the foregoing application scenarios are merely examples. During actual application, the embodiments of this application may be applied to another application scenario in which a plurality of phase-locked loops output local oscillator signals, and the local oscillator signals need to have a same phase.

In addition, the solutions provided in the embodiments of this application are intended to provide, by using the phase synchronization apparatus and a phase synchronization system, local oscillator signals with a same phase for each radio frequency transceiver chip in the multi-chip combination solution. A specific structure of the radio frequency transceiver chip is not limited.

The embodiments of this application provide the phase synchronization system, to provide the local oscillator signals with the same phase for each radio frequency transceiver chip in the multi-chip combination solution.

It should be noted that, in the embodiments of this application, "a plurality of" means two or more. In addition, it should be understood that, in descriptions of this application, terms such as "first" and "second" are merely used for differentiation and description, but cannot be understood as an indication or implication of relative importance or an indication or implication of an order. "Coupling" in this application refers to an electrical connection, and may specifically include two manners: a direct connection or an indirect connection. The following briefly describes application scenarios of the embodiments of this application.

The following further describes in detail the embodiments of this application with reference to the accompanying drawings.

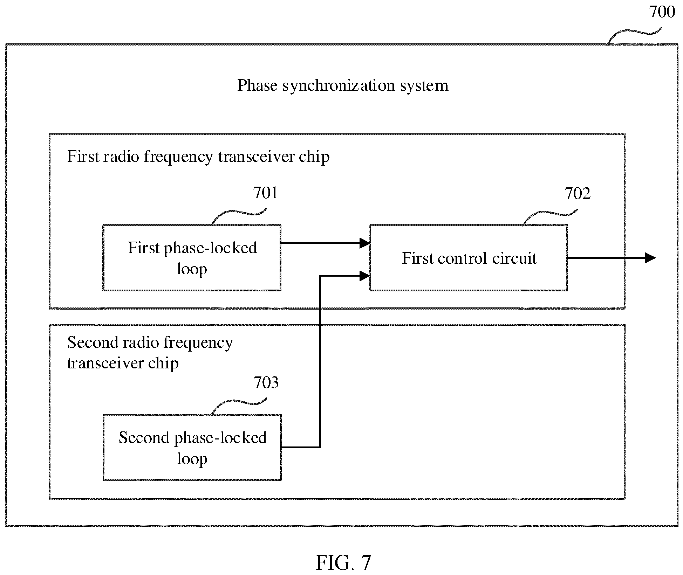

FIG. 7 shows a phase synchronization system provided in an embodiment of this application. The phase synchronization system 700 includes a first radio frequency transceiver chip and a second radio frequency transceiver chip. The first radio frequency transceiver chip includes a first phase-locked loop 701 and a first control circuit 702, and the second radio frequency transceiver chip includes a second phase-locked loop 703.

The first phase-locked loop 701 is configured to generate a first local oscillator signal. The second phase-locked loop 703 is configured to generate a second local oscillator signal. The first control circuit 702 is configured to: perform phase detection based on the first local oscillator signal and the second local oscillator signal to obtain a first phase error, generate a first control signal based on the first phase error, and perform phase control on the first phase-locked loop 701 or the second phase-locked loop 703 by using the first control signal.

During specific implementation, the first phase-locked loop 701 and the second phase-locked loop 703 may respectively generate the first local oscillator signal and the second local oscillator signal based on a same reference clock signal. To be specific, the first phase-locked loop 701 generates the first local oscillator signal based on a first reference clock signal, and the second phase-locked loop 703 generates the second local oscillator signal based on the first reference clock signal.

If the first phase-locked loop 701 and the second phase-locked loop 703 generate the local oscillator signals based on the same reference clock signal, the first local oscillator signal and the second local oscillator signal have a same frequency. In this case, the first local oscillator signal and the second local oscillator signal are local oscillator signals whose frequencies and phases are the same.

In this embodiment of this application, the first control circuit 702 performs phase detection based on the first local oscillator signal and the second local oscillator signal to obtain the first phase error, generates the first control signal based on the first phase error, and performs phase control on the first phase-locked loop 701 or the second phase-locked loop 703 by using the first control signal. The first phase error may reflect a relative phase relationship between the first local oscillator signal and the second local oscillator signal. An architecture of such a feedback control system is constructed, so that the local oscillator signals output by the first phase-locked loop 701 and the second phase-locked loop 703 have the same phase. In other words, it can be seen that the first phase error tends to be zero at an output end of a first phase detector. Specifically, when the first control signal is generated based on the first phase error and is used to control the first phase-locked loop 701, a phase of the first local oscillator signal generated by the first phase-locked loop 701 may be the same as a phase of the second local oscillator signal generated by the second phase-locked loop 703. Alternatively, when the first control signal is generated based on the first phase error and is used to control the second phase-locked loop 703, a phase of the second local oscillator signal generated by the second phase-locked loop 703 may be the same as a phase of the first local oscillator signal generated by the first phase-locked loop 701.

If the phase synchronization system 700 includes a plurality of radio frequency transceiver chips, a first phase-locked loop 701 and a first control circuit 702 may be disposed in each of the radio frequency transceiver chips, so that local oscillator signals output by the two phase-locked loops have a same phase. When local oscillator signals output by every two phase-locked loops have the same phase, local oscillator signals with a same phase may be used for a plurality of radio frequency transceiver chips.

Specifically, in this embodiment of this application, FIG. 7 is still used as an example. The first control circuit 702 may include the first phase detector (PD) configured to detect the first phase error based on the first local oscillator signal and the second local oscillator signal.

Specifically, in this embodiment of this application, the first control circuit 702 may include a first phase controller configured to generate the first control signal based on the first phase error. The first control signal is used to control a frequency division control word (which may also be referred to as a frequency division coefficient) of the first phase-locked loop or the second phase-locked loop.

In other words, operations of performing phase detection and generating the first control signal may be completed by two components of the first control circuit 702. Specifically, the first phase detector of the first control circuit 702 performs phase detection on the first local oscillator signal and the second local oscillator signal, to obtain the first phase error. Then, the first phase controller of the first control circuit 702 may generate the first control signal based on the first phase error.

During specific implementation, there may be a plurality of methods for implementing a PD. PDs can be classified into an analog PD and a digital PD based on types of output signals of the PDs. An output signal of the analog PD is an analog voltage or a current signal that represents a phase error between input signals. An output signal of the digital PD is a digital signal that represents a phase error between the input signals. The digital PD may be implemented by using a time-to-digital converter (TDC) circuit.

In addition, in this embodiment of this application, a main function of the phase controller is to process an output of a PD based on a design requirement of the control system, and output a required phase tuning value. The phase controller may be designed as a proportional controller, an integral controller, a proportional-integral controller, or another type of controller according to a system control solution. Corresponding to the PDs, phase controllers may also be classified into an analog phase controller and a digital phase controller based on types of processed signals. The analog phase controller is mainly implemented by using components such as a resistor, a capacitor, and an operational amplifier.

The digital phase controller is implemented by using a digital logic circuit or a digital signal processor.

As described above, in this embodiment of this application, the first control circuit 702 performs phase detection on the first local oscillator signal and the second local oscillator signal to obtain the first phase error. The first phase error may reflect a relative phase relationship between the first local oscillator signal and the second local oscillator signal. During specific implementation, the first phase error may have a plurality of meanings.

First meaning: The first phase error is a phase error between the first local oscillator signal and the second local oscillator signal.

In this case, the first phase detector may specifically perform detection in the following manner based on the first local oscillator signal and the second local oscillator signal to obtain the first phase error: The first phase detector detects a phase error between the first local oscillator signal and the second local oscillator signal, to obtain the first phase error.

In a first manner, the first phase detector directly detects the phase error between the first local oscillator signal and the second local oscillator signal, may generate the first control signal based on the phase error between the first local oscillator signal and the second local oscillator signal, and is configured to perform phase control on the first phase-locked loop 701 or the second phase-locked loop 703.

Second meaning: The first phase error is a phase error between the frequency-divided first local oscillator signal and the frequency-divided second local oscillator signal.

In a second manner, the first control circuit 702 further includes a first frequency divider (FDIV). The first frequency divider is coupled to the first phase-locked loop 701, and is configured to perform frequency division on the first local oscillator signal. The second radio frequency transceiver chip further includes a second frequency divider that is configured to perform frequency division on the second local oscillator signal. A frequency division ratio of the second frequency divider is the same as that of the first frequency divider. In this case, the first phase detector may specifically perform detection in the following manner based on the first local oscillator signal and the second local oscillator signal to obtain the first phase error: The first phase detector detects a phase error between the first local oscillator signal obtained by performing frequency division by the first frequency divider and the second local oscillator signal obtained by performing frequency division by the second frequency divider, to obtain the first phase error. It is assumed that the frequency division ratio of the first frequency divider is M, a frequency of the first local oscillator signal is $f_{LO\_1}$, a phase of the first local oscillator signal is $\theta_{LO\_1}$, and amplitude modulation information of the first local oscillator signal is $A_{LO\_1}$. In this case, an output signal of the first frequency divider may be expressed as:

$$S_{LO\_DIV} = A_{LO\_1} \cdot cos\left(\frac{2\pi f_{LO\_1}t + \theta_{LO\_1}}{M}\right)$$

A phase of the first local oscillator signal obtained by performing frequency division by the frequency divider is $\theta_{LO\_DIV\_1} = \frac{\theta_{LO\_1}}{M}$.

Similarly, it is assumed that a frequency division ratio of the second frequency divider is M, a frequency of the second local oscillator signal is $f_{LO\_2}$, a phase of the second local oscillator signal is $\theta_{LO\_2}$, and amplitude modulation information of the second local oscillator signal is $A_{LO\_2}$. In this case, an output signal of the second frequency divider may be expressed as:

$$S_{LO\_DIV} = A_{LO\_2} \cdot cos\left(\frac{2\pi f_{LO\_2}t + \theta_{LO\_2}}{M}\right)$$

A phase of the second local oscillator signal obtained by performing frequency division by the frequency divider is $\theta_{LO\_DIV\_2} = \frac{\theta_{LO\_2}}{M}$.

The first phase error may be expressed as:

$$\theta_{LO\_DIV\_1} - \theta_{LO\_DIV\_2} = \frac{\theta_{LO\_1}}{M} - \frac{\theta_{LO\_2}}{M} = \frac{\theta_{LO\_1} - \theta_{LO\_2}}{M}$$

Further, an output of the first phase detector (that is, the first phase error) may be expressed as:

$$E_{PD\_1} = K_{PD\_1} * \left(\theta_{LO_{DIV_1}} - \theta_{LO_{DIV_2}}\right) = \frac{K_{PD_1}}{M} * (\theta_{LO_1} - \theta_{LO_2})$$

$K_{PD\_1}$ is a conversion gain of the first phase detector.

In the second manner, after frequency division processing is performed on a local oscillator signal, subsequent phase detection and signal transmission both are performed at a low frequency. Compared with that in the foregoing first manner, a power consumption level in the second manner is significantly reduced. For example, in massive multiple-input and multiple-output (massive MIMO) antenna systems, an RF signal usually uses a frequency band above 3 GHz. A signal transmission frequency of a radio frequency transceiver chip is high. Therefore, using a high-frequency signal to perform detection and control certainly increases power consumption of the chip. In this case, the FDIV may be used to perform frequency division on the high-frequency signal. This can reduce power consumption of the chip. For another example, in a 5G beamforming scenario, the frequency of the RF signal is usually higher than 20 GHz, and the power consumption of the chip is also high. In this case, the FDIV may be used to perform frequency division on the high-frequency signal. This can reduce power consumption of the chip.

It should be noted that, for a scenario in which the transmission signal frequency of the chip is low, the first phase error may alternatively be a phase error between a frequency multiplied signal of the first local oscillator signal and a frequency multiplied signal of the second local oscillator signal. Control principles of the first phase error are similar to those in the foregoing two manners. Mutual reference may be made to the foregoing descriptions. Details are not described herein again.

In the phase synchronization system 700, the first control signal generated by the first phase-locked loop may be used to perform phase control on the first phase-locked loop, or may be used to perform phase control on the second phase-locked loop. In other words, in the first implementation, the control signal generated in this chip is used to perform phase control on a phase-locked loop in another chip. In a second implementation, the control signal generated in this chip is used to perform phase control on a phase-locked loop in this chip. For the two implementations, signal directions in the system are different. The following briefly describes the two implementations.

It is assumed that the phase synchronization system 700 includes N radio frequency transceiver chips. Each radio frequency transceiver chip includes a phase-locked loop and a control circuit coupled to the phase-locked loop. The phase-locked loop is configured to provide a local oscillator signal for the radio frequency transceiver chip. For ease of description, a phase-locked loop in an $i^{th}$ radio frequency transceiver chip is referred to as an $i^{th}$ phase-locked loop, and a control circuit in the $i^{th}$ radio frequency transceiver chip is referred to as an $i^{th}$ control circuit, where $1 \leq i < N$.

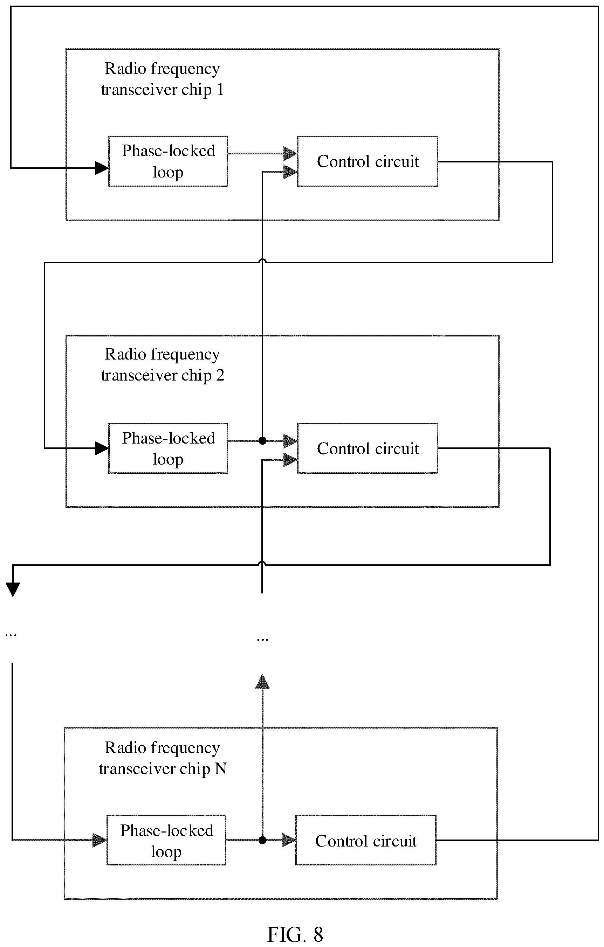

In this case, as shown in FIG. 8, in a first possible implementation, a control signal generated by a first control circuit according to the foregoing solution is used to perform phase control on a second phase-locked loop, so that a phase of a local oscillator signal generated by the second phase-locked loop is the same as a phase of a local oscillator signal generated by a first phase-locked loop; a control signal generated by a second control circuit is used to perform phase control on a third phase-locked loop, so that a phase of a local oscillator signal generated by the third phase-locked loop is the same as the phase of the local oscillator signal generated by the second phase-locked loop; ...; a control signal generated by an $i^{th}$ control circuit is used to perform phase control on an $(i + 1)^{th}$ phase-locked loop, so that a phase of a local oscillator signal generated by the $(i + 1)^{th}$ phase-locked loop is the same as a phase of a local oscillator signal generated by the $i^{th}$ phase-locked loop.

It can be learned that, in the foregoing implementation, the first phase-locked loop is used as a reference of another phase-locked loop, and a control circuit controls a phase of a local oscillator signal of the another phase-locked loop to be synchronized with a phase of a local oscillator signal of a previous phase-locked loop. In addition, no control circuit may be disposed in a last phase-locked loop. In this case, the first phase-locked loop does not need to generate the local oscillator signal based on a control signal when generating the local oscillator signal. Alternatively, a control circuit may be disposed in the last phase-locked loop, and a control signal output by the control circuit may be used to perform phase control on the first phase-locked loop. In this case, when generating the local oscillator signal, the first phase-locked loop may generate the local oscillator signal based on a control signal output by the last control circuit (this manner is used as an example in FIG. 8).

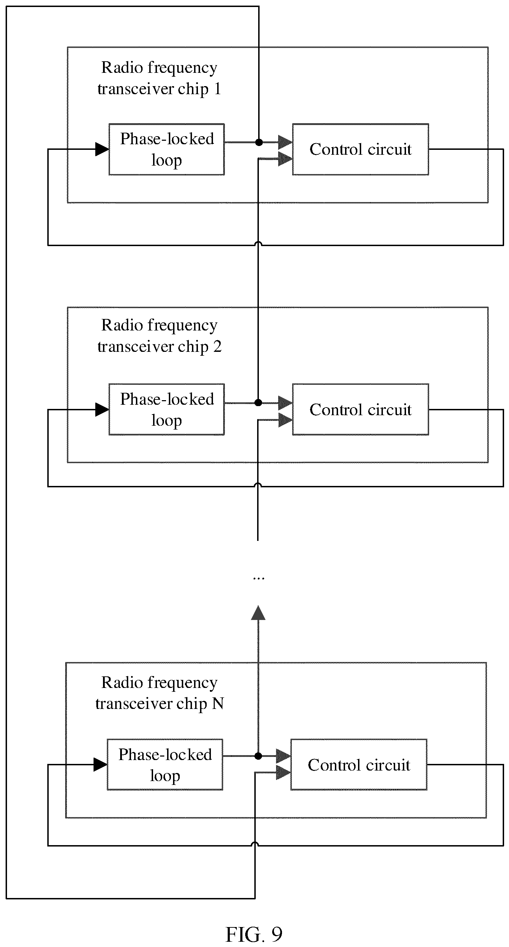

In addition, as shown in FIG. 9, in a second possible implementation, a control signal generated by an $(N - 1)^{th}$ control circuit according to the foregoing solution is used to perform phase control on an $(N - 1)^{th}$ phase-locked loop, so that a phase of a local oscillator signal generated by the $(N - 1)^{th}$ phase-locked loop is the same as a phase of a local oscillator signal generated by an $N^{th}$ phase-locked loop; a control signal generated by an $(N - 2)^{th}$ control circuit is used to perform phase control on an $(N - 2)^{th}$ phase-locked loop, so that a phase of a local oscillator signal generated by the $(N - 2)^{th}$ phase-locked loop is the same as the phase of the local oscillator signal generated by the $(N - 1)^{th}$ phase-locked loop; ...; a control signal generated by the first control circuit is used to perform phase control on the first phase-locked loop, so that a phase of the local oscillator signal generated by the first phase-locked loop is the same as the phase of the local oscillator signal generated by the second phase-locked loop.

It can be learned that, in the foregoing implementation, the $N^{th}$ phase-locked loop is used as a reference of another phase-locked loop. A control circuit in the radio frequency transceiver chip controls a phase of a local oscillator signal of a phase-locked loop in each radio frequency transceiver chip to be synchronized with a phase of a local oscillator signal of a next phase-locked loop. In addition, no control circuit may be disposed in the $N^{th}$ phase-locked loop. In this case, the $N^{th}$ phase-locked loop does not need to generate the local oscillator signal based on a control signal when generating the local oscillator signal. Alternatively, a control circuit may be disposed in the $N^{th}$ phase-locked loop, and a control signal output by the control circuit may be used to perform phase control on the $N^{th}$ phase-locked loop. In this case, when generating the local oscillator signal, the $N^{th}$ phase-locked loop may generate the local oscillator signal based on a control signal output by the first phase-locked loop (this manner is used as an example in FIG. 9).

As described above, the first phase-locked loop 701 and the second phase-locked loop 703 may respectively generate the first local oscillator signal and the second local oscillator signal based on a first reference clock signal. The first phase-locked loop 701 may generate the first local oscillator signal depending on a direction of the control signals in the system (for example, a direction of the control signals in the example of FIG. 8 are different from that of the control signals in the example of FIG. 9) in different implementations.

Implementation 1:

In the implementation 1, the first control circuit 702 performs phase control on the first phase-locked loop 701 by using the first control signal. In this case, when generating the first local oscillator signal, the first phase-locked loop 701 may be controlled by the first control signal to generate the first local oscillator signal based on the first reference clock signal.

Specifically, when generating the first local oscillator signal, the first phase-locked loop 701 may generate a frequency division control word based on the first control signal, and then generate the first local oscillator signal based on the first reference clock signal and the frequency division control word.

In other words, the first control signal may change the frequency division control word of the first phase-locked loop 701, to change the phase of the first local oscillator signal generated by the first phase-locked loop 701.

Implementation 2:

In the implementation 2, the first control circuit 702 performs phase control on the second phase-locked loop 703 by using the first control signal. In this case, when generating the second local oscillator signal, the second phase-locked loop 703 may be controlled by the first control signal to generate the second local oscillator signal based on the first reference clock signal.

In this way, for the first phase-locked loop 701, when generating the first local oscillator signal, the first phase-locked loop 701 may be controlled by a second control signal to generate the first local oscillator signal based on the first reference clock signal. In other words, the phase synchronization system 700 may further include a third radio frequency transceiver chip. The third radio frequency transceiver chip includes a third phase-locked loop and a second control circuit. The third phase-locked loop is configured to generate a third local oscillator signal. The second control circuit is configured to: perform detection based on the third local oscillator signal and the first local oscillator signal to obtain a second phase error, and generate the second control signal based on the second phase error, so that the second control signal is used by the first phase-locked loop 701 when generating the first local oscillator signal. In other words, the first control signal generated by the first control circuit 701 is output to the second phase-locked loop 703, and is used for phase control on the second phase-locked loop 703. In this case, for the first phase-locked loop 701, the phase synchronization system 700 may further include a third radio frequency transceiver chip, to generate a control signal for performing phase control on the first phase-locked loop. Specifically, the third radio frequency transceiver chip includes a third phase-locked loop and a second control circuit.

Specifically, when generating the first local oscillator signal, the first phase-locked loop 701 may generate a frequency division control word based on the second control signal, and then generate the first local oscillator signal based on the first reference clock signal and the frequency division control word.

In other words, the second control signal may change the frequency division control word of the first phase-locked loop 701, to change the phase of the first local oscillator signal generated by the first phase-locked loop 701.

Implementation 3:

In the implementation 3, the first control circuit 702 performs phase control on the second phase-locked loop 703 by using the first control signal. In this case, when generating the first local oscillator signal, the first phase-locked loop 701 may generate the first local oscillator signal based on the first reference clock signal without control of the control signal.

As mentioned in the foregoing description of a radio frequency system shown in FIG. 8, if a control signal generated by a control circuit is used to perform phase control on a phase-locked loop in another chip, the first phase-locked loop in the system may be used as a calibration reference of another phase-locked loop. When generating the local oscillator signal, the first phase-locked loop may not generate the local oscillator signal based on the control signal. Similarly, as mentioned in the description of a radio frequency system shown in FIG. 9, if a control signal generated by a control circuit is used to perform phase control on a phase-locked loop in this chip, a last phase-locked loop in the system may be used as a calibration reference of another phase-locked loop. When generating the local oscillator signal, the last phase-locked loop may not generate the local oscillator signal based on the control signal. This is the case described in the implementation 3.

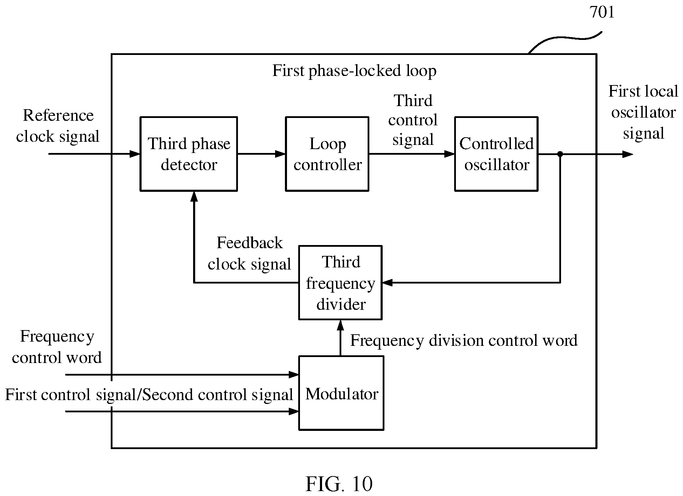

The foregoing lists three implementations in which the first phase-locked loop 701 generates the first local oscillator signal. In this embodiment of this application, the first phase-locked loop 701 has a structure similar to a structure of a phase-locked loop in a conventional technology, but differs from the phase-locked loop in the conventional technology in a signal processing manner. Specifically, refer to FIG. 10. The first phase-locked loop 701 includes: a third phase detector, configured to detect a phase error between a reference clock signal and a feedback clock signal; a loop controller, coupled to the third phase detector, and configured to generate a third control signal based on the phase error between the first reference clock signal and the feedback clock signal; a controlled oscillator (OSC), coupled to the loop controller, and configured to generate the first local oscillator signal based on the third control signal; a modulator, configured to generate the frequency division control word based on the first control signal or the second control signal, and a frequency control word; and a third frequency divider (DIV), coupled to the controlled oscillator and the modulator, and configured to generate the feedback clock signal based on the first local oscillator signal and the frequency division control word and output the feedback clock signal to the third phase detector.

The phase-locked loop in this embodiment of this application may be a phase-controllable phase-locked loop (PC-PLL), and the PC-PLL provides a local oscillator phase tuning mechanism. In this embodiment of this application, a phase error between local oscillator signals output by two PC-PLLs is determined based on an output of a phase detector. A phase controller generates a control signal based on the phase error, and the control signal finally acts on either of the two PC-PLLs, so that a phase of a local oscillator signal output by the PC-PLL is the same as a phase of a local oscillator signal output by the other PC-PLL.

A difference between the PC-PLL and the phase-locked loop in the conventional technology lies in that a modulator in the phase-locked loop in the conventional technology generates a frequency division control word based on a frequency control word when generating the frequency division control word. However, when generating the frequency division control word, the PC-PLL in this embodiment of this application needs to generate the frequency division control word based on the control signal. Specifically, a logic circuit may be added to the phase-locked loop provided in the conventional technology to form a PC-PLL, so as to implement this function. A behavior of the modulator is intervened by using a control signal, to implement a phase adjustment function of a local oscillator signal output by the PC-PLL.

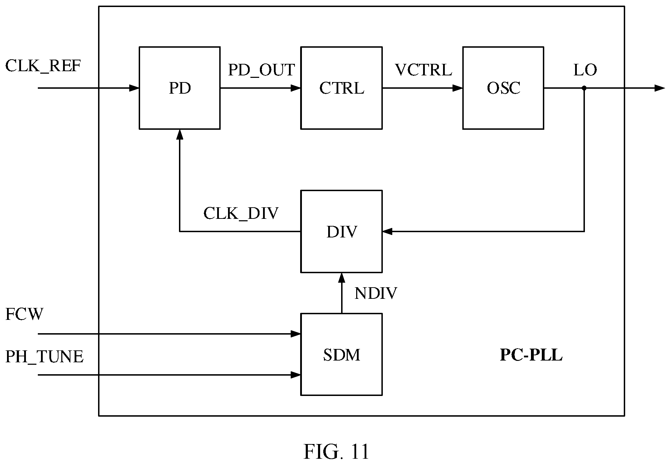

For example, a possible schematic diagram of a structure of the first phase-locked loop 701 may be shown in FIG. 11. The first phase-locked loop 701 shown in FIG. 11 may be considered as a specific example of the first phase-locked loop 701 shown in FIG. 10. Refer to FIG. 11. The first phase-locked loop 701 includes a phase detector, a loop controller, a controller oscillator, a frequency divider, and a sigma-delta modulator.

1. The phase detector (PD): The phase detector is configured to: detect a phase error between a reference clock signal CLK REF and a feedback clock signal CLK_DIV, and output a signal PD_OUT related to the phase error between the two clock signals. It is assumed that the phase of the reference clock signal is $\theta_{REF}$, the phase of the feedback clock signal is $\theta_{DIV}$, and a conversion gain of the PD is $K_{PD}$. In this case, a value of the output signal PD OUT of the PD is:

$$E_{PD}(t) = K_{PD} \cdot [\theta_{REF}(t) - \theta_{DIV}(t)]$$

The PD may be an analog PD or a digital PD based on a type of output data of the PD. The analog PD outputs a voltage or a current signal that reflects a phase error between input clocks. A phase-locked loop using the analog PD is referred to as an analog phase-locked loop. The digital PD outputs a digital signal that reflects the phase error between the input clocks. The phase-locked loop that uses the digital PD is referred to as a digital phase-locked loop.

2. Loop controller (CTRL): The loop controller may also be referred to as a loop filter in a phase-locked loop system. In the phase-locked loop system, common controllers include the following types: a proportional controller and a proportional-integral controller. It is assumed that a value of an output signal of the loop controller is $V_{CTRL}$. In this case, in an example of the proportional-integral controller, an output of the loop controller may be described as follows:

$$V_{CTRL}(t) = K_I \cdot E_{PD}(t) + K_P \cdot \int_0^t E_{PD}(\tau) \cdot d\tau$$

In the foregoing equation, $K_I$ is a proportional gain and $K_P$ is an integral gain of the proportional-integral controller.

Corresponding to types of PDs, loop controllers may also be classified into an analog controller and a digital controller based on types of processed signals. The analog controller processes analog signals such as a voltage and a current, and the controller includes parts and components such as a resistor, a capacitor, and an operational amplifier. The digital controller processes a digital signal, and the controller is usually implemented by a digital logic circuit or a digital signal processor.

3. Controlled oscillator (OSC): An output signal of the controlled oscillator is used as a local oscillator signal. A frequency of the controlled oscillator is controlled by an input control signal VCTRL of the controlled oscillator. It is assumed that a value of VCTRL is $V_{CTRL}$, and a conversion gain of the controlled oscillator is $K_V$. In this case, an output frequency of the controlled oscillator is:

$$f_{LO}(t) = f_0 + K_V \cdot V_{CTRL}(t)$$

In the foregoing equation, $f_0$ is denoted as a frequency used when the value $V_{CTRL}$ is controlled to satisfy $V_{CTRL} = 0$.

In this embodiment of this application, the phases of the first local oscillator signal and the second local oscillator signal are compared, and a comparison result is used as an indicator for determining phase synchronization. Theoretically, there is an integral relationship between phase information of a local oscillator signal and frequency information of the local oscillator signal:

$$\theta_{LO}(t) = \theta_{LO}(0) + \int_0^t f_{LO}(\tau) \cdot d\tau$$

Corresponding to the phase detectors and the loop controllers, controlled oscillators may be classified into a voltage-controlled/current-controlled oscillator and a digitally controlled oscillator based on types of control signals. A frequency control signal of the voltage-controlled/current-controlled oscillator is a voltage or current signal. A frequency control signal of the digitally controlled oscillator is a digital signal.

4. Frequency divider (DIV): The module performs frequency division on the local oscillator signal output by the controlled oscillator, and generates a feedback clock signal CLK DIV for phase comparison with the reference clock signal. It is assumed that a frequency division ratio of the frequency divider is $N_{DIV}$. In this case, a relationship between a frequency of the feedback clock signal and a frequency of the local oscillator signal satisfies:

$$f_{DIV}(t) = \frac{f_{LO}(t)}{N_{DIV}}$$

A relationship between phase information of the feedback clock signal and phase information of the local oscillator signal satisfies:

$$\theta_{DIV}(t) = \frac{\theta_{LO}(t)}{N_{DIV}}$$

In other words, a phase of the frequency-divided feedback clock signal and the phase of the local oscillator signal are scaled down based on the frequency division ratio.

5. Sigma-delta modulator (SDM): The sigma-delta modulator functions to implement a fractional frequency division function of a phase-locked loop.

According to operation principles of the phase-locked loop, a frequency of outputting a local oscillator signal by the phase-locked loop is controlled by a frequency control word (FCW). It is assumed that an expected frequency of the local oscillator signal is $f_{LO}$, and a frequency of the reference clock signal CLK REF is $f_{REF}$. In this case, a value of the frequency control word may be expressed as:

$$N_{FCW} = \frac{f_{LO}}{f_{REF}}$$

If $N_{FCW}$ is an integer, the frequency division ratio of the DIV can be directly controlled to implement functions of the phase-locked loop. In this operation mode,

$$N_{DIV} = N_{FCW}$$

During actual application, usually, the frequency control word is not an integer. In an operation mode based on this fractional frequency division ratio, a sigma-delta modulator is required to process frequency division ratio data. The sigma-delta modulator is a digital signal processing circuit. In a phase-locked loop system, the sigma-delta modulator mainly functions to convert a non-integer frequency control word into an integer frequency division sequence acceptable by the frequency divider. It is assumed that the value of the frequency control word is expressed as:

$$N_{FCW} = N_{FCW\_INTG} + N_{FCW\_FRAC}$$

In the foregoing equation, $N_{FCW\_INTG}$ is an integer part and $N_{FCW\_FRAC}$ is a fractional part of the frequency control word. After the frequency control word is processed by the sigma-delta modulator, a series of integer sequences with a change range close to $N_{FCW\_INTG}$ are output, that is,

$$N_{DIV} \in N_{FCW\_INTG} + \{\dots, -2, -1, 0, 1, 2, \dots\}$$

In the foregoing equation, $N_{DIV}$ is a frequency division control word output by the sigma-delta modulator to the frequency divider, that is, the foregoing frequency division ratio $N_{DIV}$. A change range of $N_{DIV}$ is related to a type of the sigma-delta modulator.

It can be learned that, after processing by the sigma-delta modulator, the frequency divider obtains an integer frequency division ratio that changes within a specific range. However, over a long period of time, the frequency divider obtains an average of frequency division ratios being the expected frequency control word, that is,

$$N_{FCW} = MEAN\{N_{DIV}[i]\}$$

It should be noted that the structure of the first phase-locked loop 701 described above is also applicable to another phase-locked loop in this embodiment of this application. Therefore, a specific structure of the another phase-locked loop is not described in detail in this application.

In addition, in this embodiment of this application, the first control circuit 702 may further include: a first driver, configured to: receive the first local oscillator signal, and output the driven first local oscillator signal to the second control circuit.

Further, the first control circuit 702 may further include a first buffer, configured to buffer the second local oscillator signal.

In other words, for local oscillator signals transmitted between chips, a buffer may buffer a local oscillator signal transmitted to a chip by another chip, and phase detection is further performed based on a local oscillator signal output by a phase-locked loop in the chip and the local oscillator signal transmitted to the chip by the another chip. Similarly, when the local oscillator signal output by the phase-locked loop in the chip is output to the another chip for phase detection, a driver may output, to the another chip, the local oscillator signal output by the phase-locked loop in the chip. The driver may be coupled to a buffer in the another chip, to implement of a local oscillator signal between chips.

As described above, in this embodiment of this application, the first control circuit 702 may directly detect the phase error between the first local oscillator signal and the second local oscillator signal, to obtain the first phase error, or may detect the phase error between the frequency-divided first local oscillator signal and the frequency-divided second local oscillator signal, to obtain the first phase error. Therefore, for the second implementation, the first driver of the first control circuit 702 is configured to output the frequency-divided first local oscillator signal to the second control circuit, and the first buffer of the first control circuit 702 is configured to buffer the frequency-divided second local oscillator signal.

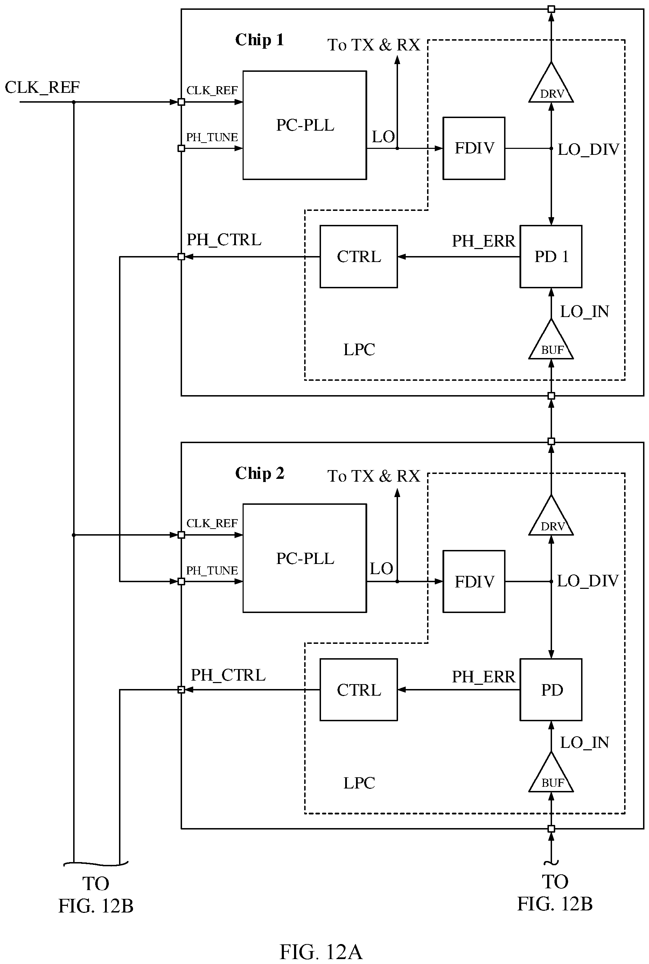

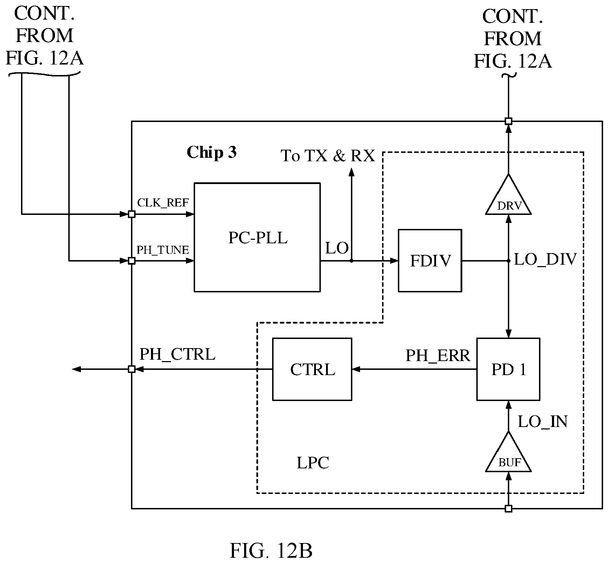

With reference to the foregoing description, in the phase synchronization system 700, the first control circuit 702 may include the first phase detector, the first phase controller, the first frequency divider, the first driver, and the first buffer. The control circuit is applied to a phase synchronization system including three radio frequency transceiver chips. The phase synchronization system may be shown in FIG. 12A and FIG. 12B.

In the phase synchronization system shown in FIG. 12 A and FIG. 12B, one PC-PLL and one local oscillator phase controller (LPC) are disposed in each chip. The PC-PLL may be considered as a specific example of the first phase-locked loop 701, and the LPC may be considered as a specific example of the first control circuit 702.

In an example of a chip 1, a PC-PLL is configured to generate a local oscillator signal, an FDIV of the LPC is configured to perform frequency division on the local oscillator signal generated by the PC-PLL, a PD 1 is configured to detect a phase error between frequency-divided local oscillator signals in the chip 1 and a chip 2, and a CTRL is configured to generate a control signal PH TUNE based on the phase error. The control signal is used by a PC-PLL in the chip 2 to generate a local oscillator signal. In this way, a phase of the local oscillator signal generated by the PC-PLL in the chip 2 is the same as a phase of the local oscillator signal generated by the PC-PLL in the chip 1.

In addition, composition and operation principles of PC-PLLs and LPCs in the chip 2 and the chip 3 are similar to those in the chip 1, and details are not described herein again.

It should be noted that, in the phase synchronization system shown in FIG. 12A and FIG. 12B, only a connection relationship between the chips is shown, and composition of a transceiver channel in a radio frequency transceiver chip is not explicitly shown. The composition of the transceiver channel in the radio frequency transceiver chip is not specifically limited in this embodiment of this application. In addition, a quantity of radio frequency transceiver chips included in the phase synchronization system is not specifically limited in this embodiment of this application.

In the phase synchronization system 700 provided in this embodiment of this application, transmission of local oscillator signals between chips may be implemented by using a driver and a buffer. However, during transmission of the local oscillator signals between the chips, a delay on a transmission path causes a phase change of the local oscillator signals.

On a local oscillator signal transmission path from an $(n + 1)^{th}$ chip to an $n^{th}$ chip, factors that cause a phase change mainly include: (1) a driver that sends a local oscillator signal on the $(n + 1)^{th}$ chip; (2) a buffer that receives the local oscillator signal on the $n^{th}$ chip; (3) hardware cabling of the transmission path between the chips. In analysis of this example, phase changes caused by the above factors can be expressed as one parameter $\theta_{PATH\_n}$. After a phase change introduced on the transmission path is considered, an output of the first phase detector is:

$$E_{PD\_n} = K_{PD\_n} \cdot \left( \theta_{LO\_DIV\_n} - \theta_{LO\_IN\_n} \right)$$

$$= K_{PD\_n} \cdot \left[ \theta_{LO\_DIV\_n} - \left( \theta_{LO\_DIV\_n+1} + \theta_{PATH\_n} \right) \right]$$

$$= \frac{K_{PD\_n}}{M} \cdot \left[ \theta_{LO\_n} - \left( \theta_{LO\_n+1} + M \cdot \theta_{PATH\_n} \right) \right]$$

It can be learned from the foregoing formula that, even if a feedback loop reaches a stable state, a phase error $M \cdot \theta_{PATH\_n}$ caused by transmission of local oscillator signals between two chips still exists between the local oscillator signals in the chips.

To reduce the phase error introduced on the transmission path, in a possible design, the first control circuit 702 may further include: a second phase detector, configured to perform detection based on the third local oscillator signal and the first local oscillator signal, to obtain a third phase error. The second control circuit generates the second control signal based on a difference between the second phase error and the third phase error.

As described above, when generating the first local oscillator signal, the first phase-locked loop 701 may generate the first local oscillator signal based on the first reference clock signal and the second control signal. The second control signal is a control signal generated by the second control circuit, and the second control circuit is configured to: perform detection based on the first local oscillator signal and the third local oscillator signal generated by the third phase-locked loop, to obtain the second phase error, and generate the second control signal according to the second phase error.

In this case, when the first control circuit 702 includes the second phase detector, the second phase detector also performs detection based on the first local oscillator signal and the third local oscillator signal generated by the third phase-locked loop, to obtain the second phase error. The first phase-locked loop 701 and the first control circuit 702 are integrated into the first radio frequency transceiver chip, and the second control circuit and the third phase-locked loop are integrated into the third radio frequency transceiver chip. Therefore, when the second control circuit detects the second phase error, the second phase error is detected after the first local oscillator signal is transmitted from the first radio frequency transceiver chip to the third radio frequency transceiver chip. The second phase error includes a phase error caused on a transmission path from the first radio frequency transceiver chip to the third radio frequency transceiver chip. When the second phase detector detects the third phase error, the third phase error is detected after the third local oscillator signal is transmitted from the third radio frequency transceiver chip to the first radio frequency transceiver chip. The third phase error includes a phase error caused on a transmission path from the third radio frequency transceiver chip to the first radio frequency transceiver chip. Therefore, when the second control circuit generates the second control signal based on a difference between the second phase error and the third phase error, the difference between the second phase error and the third phase error can offset the phase error caused on a transmission path.

Similarly, the second radio frequency transceiver chip may further include a third control circuit coupled to the second phase-locked loop 703. The third control circuit may also perform phase detection based on the first local oscillator signal and the second local oscillator signal, to obtain a fourth phase error, and transmit the fourth phase error to the first control circuit 702 in the first radio frequency transceiver chip. When generating the first control signal, the first control circuit 702 may generate the first control signal based on a difference between the first phase error and the fourth phase error.

The first phase-locked loop 701 and the first control circuit 702 are integrated into the first radio frequency transceiver chip, and the second phase-locked loop 703 and the third control circuit are integrated into the second radio frequency transceiver chip. Therefore, when the first control circuit 702 detects the first phase error, the first phase error is detected after the second local oscillator signal is transmitted from the second radio frequency transceiver chip to the first radio frequency transceiver chip. The first phase error includes a phase error caused on a transmission path from the second radio frequency transceiver chip to the first radio frequency transceiver chip. When the third control circuit detects the fourth phase error, the fourth phase error is detected after the first local oscillator signal is transmitted from the first radio frequency transceiver chip to the second radio frequency transceiver chip. The fourth phase error includes a phase error caused on a transmission path from the first radio frequency transceiver chip to the second radio frequency transceiver chip. Therefore, when the first control circuit 702 generates the first control signal based on the difference between the first phase error and the fourth phase error, the difference between the first phase error and the fourth phase error can offset a phase error caused on a transmission path.

In this embodiment of this application, a manner in which the two phase detectors separately perform phase detection on a phase error between two local oscillator signals is referred to as "bidirectional phase detection".

In the foregoing implementation, the first control circuit 702 may further include a second driver, configured to: receive the first local oscillator signal, and output the driven first local oscillator signal to the third control circuit. Adaptively, the third control circuit may further include a buffer configured to buffer the first local oscillator signal.

In addition, the first control circuit 702 may further include a second buffer configured to buffer the third local oscillator signal. Adaptively, the second control circuit may further include a driver configured to drive output of the third local oscillator signal

In this way, during transmission of each local oscillator signal between chips, the local oscillator signal passes through both a driver and a buffer on the transmission path. When drivers and buffers in the system have same specifications, it may be considered that phase errors caused during transmission of the local oscillator signals between the chips are approximately the same. Therefore, when a control signal is generated based on a difference between two phase errors (for example, the first control circuit 702 generates the first control signal based on the difference between the first phase error and the fourth phase error), a phase error caused on the transmission path can be offset.

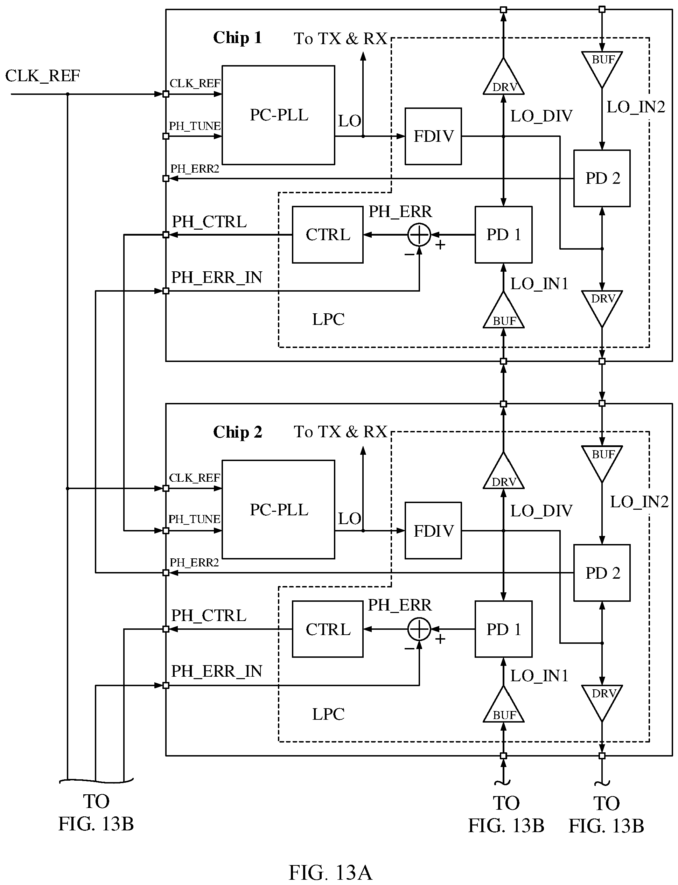

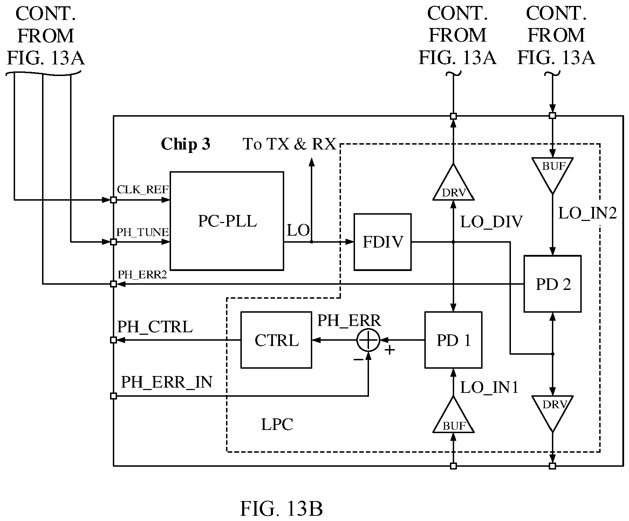

For example, to implement the foregoing "bidirectional phase detection" solution, a group of phase detectors (PDs 2) may be added to each chip of the phase synchronization system shown in FIG. 12A and FIG. 12B. As shown in FIG. 13A and FIG. 13B, an original phase detector of an LPC of each chip is denoted as a PD 1. A newly added phase detector is denoted as a PD 2, to implement bidirectional phase detection. The LPC can comprehensively calculate a phase error between local oscillator signals of two chips based on results of phase detection in two directions.

Operation principles of bidirectional phase detection are that PDs of two chips detect phase errors between local oscillator signals in two directions:

1. Direction 1: Transmit the frequency-divided local oscillator signal from the $(n + 1)^{th}$ chip to the $n^{th}$ chip. In this direction, a PD 1 of the $n^{th}$ chip detects a phase error between the local oscillator signals on the two chips. In consideration of the phase error introduced on the local oscillator signal transmission path, an output of the PD 1 of the $n^{th}$ chip satisfies:

$$E_{PD1\_n} = \frac{K_{PD1\_n}}{M} \cdot \left[ \theta_{LO\_n} - \left( \theta_{LO\_n+1} + M \cdot \theta_{PATH1\_n} \right) \right]$$

In the foregoing equation, $E_{PD1\_n}$ is an output result of the PD 1 of the $n^{th}$ chip, $G_{PD1\_n}$ is a conversion gain of the PD 1 of the $n^{th}$ chip, and $\theta_{PATH1\_n}$ is a phase change introduced on a local oscillator signal transmission path from the $(n + 1)^{th}$ chip to the $n^{th}$ chip.

2. Direction 2: Transmit the frequency-divided local oscillator signal from the $n^{th}$ chip to the $(n + 1)^{th}$ chip. In this direction, a PD 2 of the $(n + 1)^{th}$ chip detects a phase error between local oscillator signals on the two chips. It is assumed that a phase error introduced on a path from the nth chip to the (n + 1)th chip is $\theta_{PATH2\_n}$. In this case, an output of the PD 2 of the (n + 1)th chip is:

$$E_{PD2\_n+1} = \frac{G_{PD2\_n+1}}{M} \cdot \left[\theta_{LO\_n+1} - \left(\theta_{LO\_n} + M \cdot \theta_{PATH2\_n}\right)\right]$$

In the foregoing equation, $G_{PD2\_n+1}$ is a conversion gain of the PD 2 of the (n + 1)th chip.

According to a result of the foregoing bidirectional phase detection, an output result of the PD 2 of the (n + 1)th chip is sent to the nth chip, and a difference between the output result and the output result of the PD 1 of the nth chip may be obtained:

$$E_{PD\_n} = E_{PD1\_n} - E_{PD2\_n+1}$$

Because a plurality of chips that constitute a radio frequency system are usually of a same model, modules of the chips (including PDs 1 and PDs 2 of the chips, and drivers and buffers in both transmission directions) have a same design. Therefore, it can be considered that the following approximate relationship exists:

$$K_{PD1\_n} \approx K_{PD2\_n+1} \approx K_{PD}$$

$$\theta_{PATH1\_n} \approx \theta_{PATH2\_n} \approx \theta_{PATH}$$

Therefore, the following can be obtained:

$$E_{PD\_n} = \frac{2 \cdot K_{PD}}{M} \cdot \left(\theta_{LO\_n} - \theta_{LO\_n+1}\right)$$

A phase error value obtained after the difference is obtained is transferred to a controller for further processing, and a control signal for controlling a phase of a PC-PLL of the (n + 1)th chip is obtained. The feedback control system is used to finally synchronize the local oscillator signals of the two chips.

It should be noted that, in FIG. 13A and FIG. 13B, three radio frequency transceiver chips are used to describe the method for implementing the foregoing "bidirectional phase detection". Application of two chips or more chips may be deduced in the same way. Details are not described in this embodiment of this application.

The foregoing mainly describes the phase synchronization system 700 provided in this embodiment of this application. It can be learned that information transmission between chips needs to be performed when the foregoing solution is used. For example, the first control signal generated by the first phase-locked loop 701 may need to be transmitted to the second phase-locked loop 703, to perform phase control on the second phase-locked loop 703. For another example, the fourth phase error detected by the third control circuit coupled to the second phase-locked loop 703 may need to be transmitted to the first control circuit 702, so that the first control circuit generates the first control signal. During actual application, the foregoing information transmission between the chips may be implemented through a dedicated signal channel. However, the dedicated signal channel of this type usually occupies more hardware resources, and increases design complexity.

In this embodiment of this application, a control signal and a digital interface in the system may be further reused, to implement information transmission between the chips.

In a possible design, in the phase synchronization system 700, the first radio frequency transceiver chip further includes a first digital interface, and the second radio frequency transceiver chip further includes a second digital interface. The phase synchronization system 700 further includes a control chip. The first digital interface is coupled to the first control circuit 702, and is configured to receive and output the first control signal. The control chip is coupled to the first digital interface and the second digital interface, and is configured to transmit, to the second digital interface, the first control signal output by the first digital interface. The second digital interface is coupled to the second phase-locked loop 703.

The first digital interface and the second digital interface may be universal digital interfaces (INTFs). The INTF may be used as a common interface for signal transmission between chips. A digital interface module of this type is usually provided on a radio frequency transceiver chip, and is used as a universal interface for an upper-layer system to deliver an instruction to the radio frequency transceiver chip, or for an upper-layer system to collect status information from the radio frequency transceiver chip. In this embodiment of this application, this interface may be directly reused for information transmission between the chips, and resources such as a hardware pin do not need to be added.

The control chip may be a master control chip in the system. The master control chip bears software and hardware functions of the upper-layer system, and communicates with the radio frequency transceiver chip through the universal digital interface in a form of instructions or data. In this embodiment of this application, the master control chip may be directly reused for information transmission between the chips.

It should be noted that, in this embodiment of this application, the control chip may be considered as a part of the phase synchronization apparatus 700, or may be considered as an independent module independent of the phase synchronization apparatus 700 in the system.

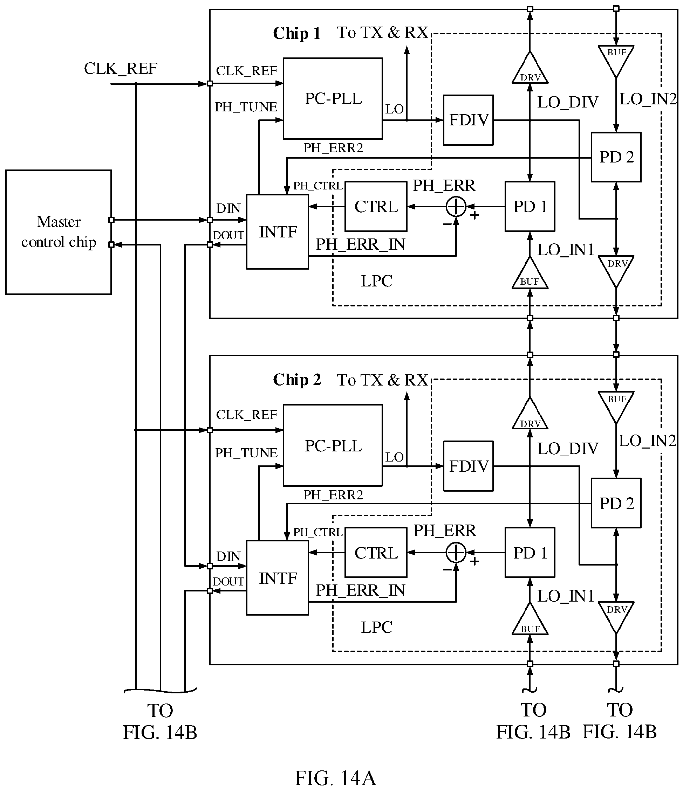

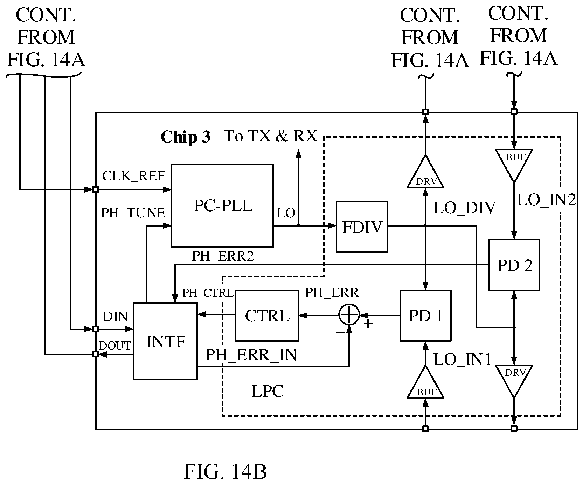

The phase synchronization system shown in FIG. 13A and FIG. 13B is used as an example. If the phase synchronization system reuses the master control chip and the INTF for information transmission between the chips, the phase synchronization system may be shown in FIG. 14A and FIG. 14B. An LPC module is implemented by using a digital structure. To be specific, both a PD 1 and a PD 2 are digital phase detectors, and a CTRL is a digital controller. Therefore, signals transmitted between chips all are digital signals. In the phase synchronization system shown in FIG. 14A and FIG. 14B, data communication initiated by a master control chip includes the following steps: (1) Read, through a universal digital interface on an $n^{th}$ chip, a PH CTRL signal output by a controller of the $n^{th}$ chip, and then send the signal as PH TUNE to a PC-PLL module through a universal digital interface on an $(n + 1)^{th}$ chip. (2) Read PH ERR2 output by a phase detector PD 2 of the $(n + 1)^{th}$ chip through the universal digital interface of the $(n + 1)^{th}$ chip, and then send the signal as the PH_ERR_IN to an LPC through the universal digital interface of the $n^{th}$ chip.

In the phase synchronization system shown in FIG. 14A and FIG. 14B, a universal digital interface between the master control chip and each radio frequency transceiver chip uses a daisy-chain topology structure. In this topology structure, the master control chip first sends instructions or data to a first chip through a universal digital interface on the first chip. The digital interface on the first chip determines, based on received information, whether the instructions or data is sent to the current chip. If it is determined that the received information is sent by the master control chip to the current chip, processing is performed on the first chip. Otherwise, the received instructions or data is sent to a universal digital interface on a second chip through the universal digital interface on the first chip. Similar processing is performed on the second chip, and the chips are sequentially cascaded. An advantage of the daisy-chain topology structure is that the master control chip needs only one group of digital interfaces to communicate with a plurality of radio frequency transceiver chips. As a quantity of radio frequency transceiver chips in the phase synchronization system increases, interfaces may be sequentially cascaded, without affecting an information transmission mechanism between the master control chip and the radio frequency transceiver chip.

In addition to the daisy-chain topology structure described above, a star topology structure can also be used. In the star topology structure, both the master control chip and each radio frequency transceiver chip include a group of dedicated universal digital interfaces. To be specific, digital interface modules with the same quantity as the radio frequency transceiver chips need to be integrated into the master control chip. The master control chip can directly transmit instructions or data to each radio frequency transceiver chip by using the star topology structure, and the instructions or data does not need to be forwarded by the chip.

In all of the foregoing examples, each radio frequency transceiver chip includes one phase-locked loop and one control circuit. During actual application, a plurality of phase-locked loops and a plurality of corresponding control circuits may be disposed in each chip.

With development of chip technologies, a scale of a single radio frequency transceiver chip is constantly expanding. A quantity of radio frequency channels integrated into a chip increases gradually. Therefore, a plurality of phase-locked loops may be integrated into each radio frequency transceiver chip, and each phase-locked loop is configured to provide a local oscillator signal for a corresponding radio frequency channel. In this embodiment of this application, one control circuit may be configured for each of the plurality of phase-locked loops. In this way, local oscillator signals of all the radio frequency channels in the chip can be synchronized.

In other words, the first radio frequency transceiver chip may further include: a fourth phase-locked loop, configured to generate a fourth local oscillator signal; and a fourth control circuit, configured to: perform detection based on the fourth local oscillator signal and the first local oscillator signal to obtain a fifth phase error, generate a fourth control signal based on the fifth phase error, and perform phase control on the first phase-locked loop or the fourth phase-locked loop by using the fourth control signal.

The first phase-locked loop may be configured to provide a local oscillator signal for a part of radio frequency channels in the first radio frequency transceiver chip, and the fourth phase-locked loop may be configured to provide a local oscillator signal for another part of radio frequency channels in the first radio frequency transceiver chip. According to the foregoing solution, the first phase-locked loop and the fourth phase-locked loop in the first radio frequency transceiver chip may output local oscillator signals with a same phase. In this way, local oscillator signals with a same phase are provided for all radio frequency channels in the first radio frequency transceiver chip.

24

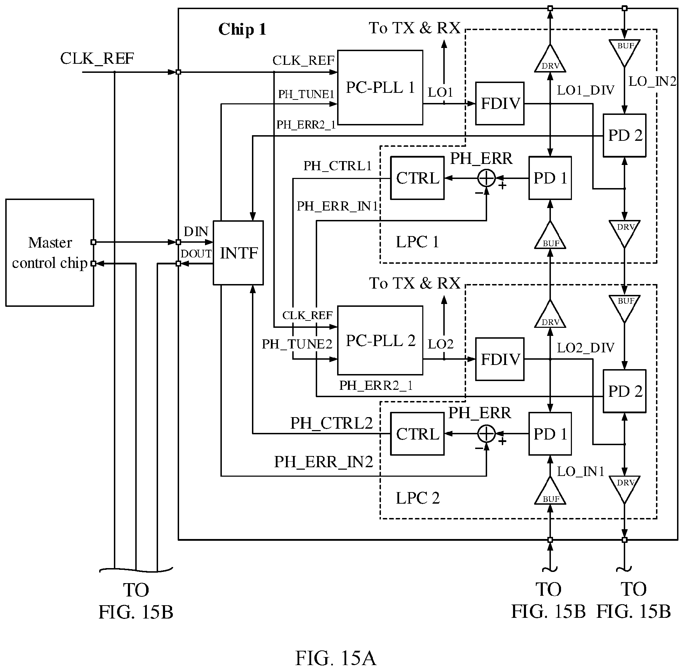

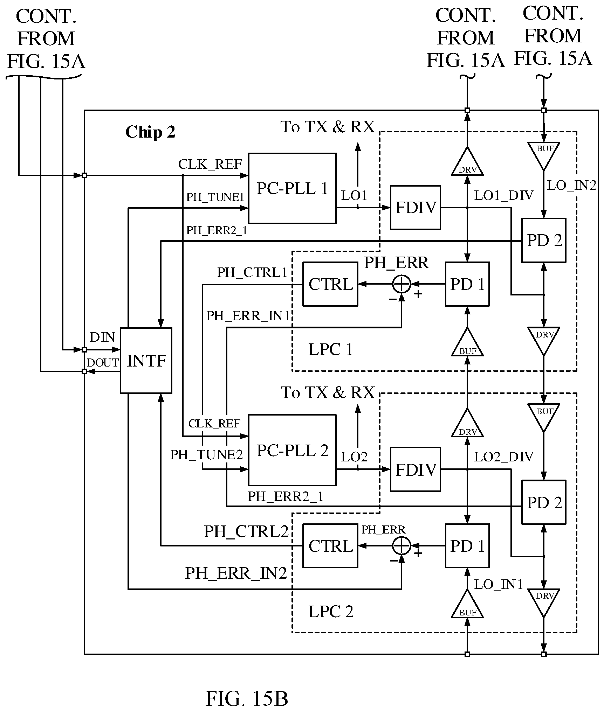

For example, as shown in FIG. 15A and FIG. 15B, two phase-locked loops and two control circuits may be disposed in one radio frequency transceiver chip, and each phase-locked loop is configured to provide a local oscillator signal for a radio frequency channel corresponding to the phase-locked loop.

In the radio frequency system shown in FIG. 15A and FIG. 15B, the foregoing "bidirectional phase detection" solution is used for local oscillator signals respectively output by two phase-locked loop modules on a same chip, a phase control signal is output by a first local oscillator phase controller (LPC 1), and a phase of a second phase controllable phase-locked loop (PC-PLL 2) is adjusted. A cross-module feedback control loop integrated into a single chip is used to implement phase synchronization between local oscillator signals output by two phase-locked loops on the single chip.

It can be learned that, in the solution shown in FIG. 15A and FIG. 15B, the phases of the local oscillator signals output by the two phase-locked loops on the single chip may be synchronized by using the feedback control loop integrated into the chip. A universal digital interface is used to transfer information between the two chips, so that a feedback control loop between the chips is established. The feedback control loop between the chips may be used to implement phase synchronization between a local oscillator signal output by a second phase-locked loop module on the first chip and a local oscillator signal output by the first phase-locked loop module on the second chip. Therefore, phase synchronization between local oscillator signals of all radio frequency transceiver chips in the radio frequency system can be implemented based on phase synchronization between local oscillator signals in a chip and phase synchronization between local oscillator signals between chips.

It should be noted that, in the examples of this application, a quantity of chips included in the phase synchronization system and a quantity of phase-locked loops (and control circuits) included in each chip are both examples. During actual application, the quantity of chips included in the phase synchronization system and the quantity of phase-locked loops (and control circuits) included in each chip may be set as required. This is not specifically limited in this embodiment of this application.

To sum up, according to the phase synchronization system 700 provided in this embodiment of this application, the first control circuit 702 performs phase detection based on the first local oscillator signal and the second local oscillator signal to obtain the first phase error, generates the first control signal based on the first phase error, and performs phase control on the first phase-locked loop 701 or the second phase-locked loop 703 by using the first control signal. The first phase error may reflect a relative phase relationship between the first local oscillator signal and the second local oscillator signal. An architecture of such a feedback control system is constructed, so that the local oscillator signals output by the first phase-locked loop 701 and the second phase-locked loop 703 have the same phase. In other words, it can be seen that the first phase error tends to be zero at an output end of a first phase detector. Because the first phase-locked loop 701 is placed on the first radio frequency transceiver chip, and the second phase-locked loop 703 is placed on the second radio frequency transceiver chip, phase synchronization between the local oscillator signals of the two radio frequency transceiver chips may be implemented according to the solution provided in this embodiment of this application. Specifically, when the first control signal is generated based on the first phase error and is used to control the first phase-locked loop 701, a phase of the first local oscillator signal generated by the first phase-locked loop 701 may be the same as a phase of the second local oscillator signal generated by the second phase-locked loop 703. Alternatively, when the first control signal is generated based on the first phase error and is used to control the second phase-locked loop 703, a phase of the second local oscillator signal generated by the second phase-locked loop 703 may be the same as a phase of the first local oscillator signal generated by the first phase-locked loop 701.

Phase synchronization between local oscillator signals of a plurality of chips can be implemented by using the phase synchronization system 700.

During actual application, the first radio frequency transceiver chip further includes a plurality of first transmission channels. The first phase-locked loop is specifically configured to provide the first local oscillator signal for the plurality of first transmission channels. The second radio frequency transceiver chip further includes a plurality of second transmission channels. The second phase-locked loop is specifically configured to provide the second local oscillator signal for the plurality of second transmission channels. The plurality of first transmission channels and the plurality of second transmission channels are used to support multiple-input multiple-output (MIMO) transmission.

The signals transmitted through the first transmission channels and the second transmission channels may be 5G new radio (NR) signals.

In another application scenario, the first radio frequency transceiver chip alternatively includes a plurality of first transmission channels. The first phase-locked loop is specifically configured to provide the first local oscillator signal for the plurality of first transmission channels. The second radio frequency transceiver chip alternatively includes a plurality of second transmission channels. The second phase-locked loop is specifically configured to provide the second local oscillator signal for the plurality of second transmission channels. The plurality of first transmission channels and the plurality of second transmission channels are used to support phased array transmission.

The signals transmitted through the first transmission channels and the second transmission channels may be 5G NR signals.

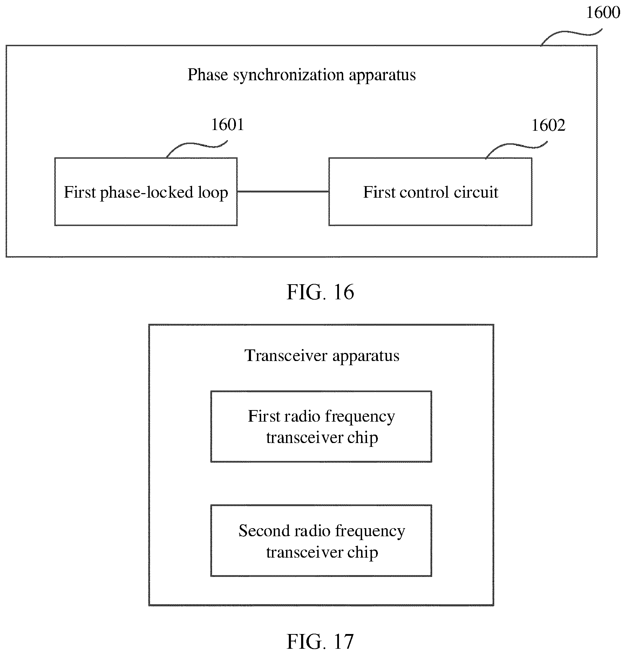

Based on the same inventive idea, an embodiment of this application provides a phase synchronization apparatus. Refer to FIG. 16. The phase synchronization apparatus 1600 includes a first phase-locked loop 1601 and a first control circuit 1602 that are integrated into a first radio frequency transceiver chip.

The first phase-locked loop 1601 is configured to generate a first local oscillator signal.

The first control circuit 1602 is configured to: perform detection based on the first local oscillator signal and a second local oscillator signal generated by a second phase-locked loop in a second radio frequency transceiver chip, to obtain a first phase error; generate a first control signal based on the first phase error; and perform phase control on the first phase-locked loop 1601 or the second phase-locked loop by using the first control signal.

It should be noted that the phase synchronization apparatus 1600 shown in FIG. 16 may be understood as a phase-locked loop and a control circuit that are integrated into a specific radio frequency transceiver chip, to provide a local oscillator signal for the radio frequency transceiver chip. Operation principles and processing logic of the phase-locked loop and the control circuit in the phase synchronization apparatus 1600 are the same as those of the phase-locked loop and the control circuit in the phase synchronization system 700.

Specifically, the first control circuit 1602 may include the first phase detector, configured to perform detection based on the first local oscillator signal and the second local oscillator signal to obtain the first phase error.

Specifically, the first control circuit 1602 may include a first phase controller, configured to generate the first control signal based on the first phase error. The first control signal is used to control a frequency division control word of the first phase-locked loop 1601 or the second phase-locked loop.

The first phase controller is any one of a proportional controller, an integral controller, or a proportional-integral controller.

Optionally, the first phase-locked loop 1601 is specifically configured to generate the first local oscillator signal based on a first reference clock signal. The first reference clock signal is a reference clock signal based on which the second phase-locked loop generates the second local oscillator signal

Optionally, the first phase-locked loop 1601 is specifically configured to be controlled by the first control signal to generate the first local oscillator signal based on the first reference clock signal.

Optionally, the first phase-locked loop 1601 is specifically configured to be controlled by a second control signal to generate the first local oscillator signal based on the first reference clock signal. The second control signal is a control signal generated by a second control circuit in a third radio frequency transceiver chip. The second control circuit is configured to: perform detection based on the first local oscillator signal and a third local oscillator signal generated by a third phase-locked loop in the third radio frequency transceiver chip, to obtain a second phase error; and generate the second control signal based on the second phase error.

Further, the first control circuit 1602 includes a first driver, configured to: receive the first local oscillator signal, and output the driven first local oscillator signal to the second control circuit.

Correspondingly, the first control circuit 1602 further includes a first buffer, configured to buffer the second local oscillator signal

In a possible implementation, the first control circuit 1602 includes a second phase detector, configured to perform detection based on the third local oscillator signal and the first local oscillator signal to obtain a third phase error. The third phase error is used for the second control circuit to generate the second control signal based on a difference between the second phase error and the third phase error.

In this case, the first control circuit 1602 may generate the first control signal based on the first phase error in the following manner: The first control circuit 1602 generates the first control signal based on a difference between the first phase error and a fourth phase error. A third control circuit coupled to the second phase-locked loop in the second radio frequency transceiver chip performs detection based on the first local oscillator signal and the second local oscillator signal to obtain the fourth phase error.

In addition, the first control circuit 1602 includes a second driver, configured to: receive the first local oscillator signal, and output the driven first local oscillator signal to the third control circuit. The first control circuit 1602 further includes a second buffer, configured to buffer the third local oscillator signal.

In a first implementation, the first control circuit 1602 may perform detection in the following manner based on the first local oscillator signal and the second local oscillator signal to obtain the first phase error: The first control circuit 1602 detects a phase error between the first local oscillator signal and the second local oscillator signal, to obtain the first phase error.

In a second implementation, the first control circuit 1602 further includes a first frequency divider, coupled to the first phase-locked loop 1601, and configured to perform frequency division on the first local oscillator signal. In this case, when performing detection based on the first local oscillator signal and the second local oscillator signal to obtain the first phase error, the first control circuit 1602 is specifically configured to detect a phase error between the first local oscillator signal obtained by performing frequency division by the first frequency divider and the second local oscillator signal obtained by performing frequency division by a second frequency divider in the third control circuit, to obtain the first phase error. A frequency division ratio of the second frequency divider is the same as that of the first frequency divider.

In addition, the first phase-locked loop 1601 may include: a third phase detector, configured to detect a phase error between the first reference clock signal and a feedback clock signal; a loop controller, coupled to the third phase detector, and configured to generate a third control signal based on the phase error between the first reference clock signal and the feedback clock signal; a controlled oscillator, coupled to the loop controller, and configured to generate the first local oscillator signal based on the third control signal; a modulator, configured to generate a frequency division control word based on the first control signal or the second control signal, and a frequency control word; and a third frequency divider, coupled to the controlled oscillator and the modulator, and configured to: generate the feedback clock signal based on the first local oscillator signal and the frequency division control word, and output the feedback clock signal to the third phase detector.

To implement signal transmission between chips, the phase synchronization apparatus 1600 provided further includes a first digital interface. The first digital interface is coupled to the first control circuit 1602, and is configured to receive the first control signal and output the first control signal to a control chip. The control chip is coupled to the first digital interface and a second digital interface in the second radio frequency transceiver chip, and is configured to transmit, to the second digital interface, the first control signal output by the first digital interface. The second digital interface is coupled to the second phase-locked loop.

In addition, when one radio frequency transceiver chip includes a large quantity of radio frequency channels, the first radio frequency transceiver chip further includes: a fourth phase-locked loop, configured to generate a fourth local oscillator signal; and a fourth control circuit, configured to: perform detection based on the fourth local oscillator signal and the first local oscillator signal to obtain a fifth phase error, generate a fourth control signal based on the fifth phase error, and perform phase control on the first phase-locked loop 1601 or the fourth phase-locked loop by using the fourth control signal.

The first phase-locked loop may be configured to provide a local oscillator signal for a part of radio frequency channels in the first radio frequency transceiver chip, and the fourth phase-locked loop may be configured to provide a local oscillator signal for another part of radio frequency channels in the first radio frequency transceiver chip.

It should be noted that the phase synchronization system 700 shown in FIG. 7 may be considered as a radio frequency system using a multi-chip combination solution, and the phase synchronization apparatus 1600 shown in FIG. 16 may be considered as an apparatus that is in the phase synchronization system 700 shown in FIG. 7 and that is configured to provide a local oscillator signal for a specific radio frequency transceiver chip. For operation principles, implementations, and technical effects that are not described in detail in the phase synchronization apparatus 1600, refer to related description of the phase synchronization system 700. Details are not described herein again.

During actual application, the first radio frequency transceiver chip further includes a plurality of first transmission channels. The first phase-locked loop is specifically configured to provide the first local oscillator signal for the plurality of first transmission channels. The second radio frequency transceiver chip further includes a plurality of second transmission channels. The second phase-locked loop is specifically configured to provide the second local oscillator signal for the plurality of second transmission channels. The plurality of first transmission channels and the plurality of second transmission channels are used to support MIMO transmission.

The signals transmitted through the first transmission channels and the second transmission channels may be 5G NR signals.

In another application scenario, the first radio frequency transceiver chip alternatively includes a plurality of first transmission channels. The first phase-locked loop is specifically configured to provide the first local oscillator signal for the plurality of first transmission channels. The second radio frequency transceiver chip alternatively includes a plurality of second transmission channels. The second phase-locked loop is specifically configured to provide the second local oscillator signal for the plurality of second transmission channels. The plurality of first transmission channels and the plurality of second transmission channels are used to support phased array transmission.

The signals transmitted through the first transmission channels and the second transmission channels may be 5G NR signals.

Based on the same inventive idea, an embodiment of this application provides a transceiver apparatus. Refer to FIG. 17. The transceiver apparatus includes a first radio frequency transceiver chip and a second radio frequency transceiver chip of a phase synchronization system 700.

The first radio frequency transceiver chip further includes a plurality of first transmission channels. The first phase-locked loop is specifically configured to provide the first local oscillator signal for the plurality of first transmission channels. The second radio frequency transceiver chip further includes a plurality of second transmission channels. The second phase-locked loop is specifically configured to provide the second local oscillator signal for the plurality of second transmission channels. The plurality of first transmission channels and the plurality of second transmission channels are used to support MIMO transmission or phased array transmission. The signals transmitted through the first transmission channels and the second transmission channels may be 5G NR signals.

Definitely, a person skilled in the art can make various modifications and variations to the embodiments of this application without departing from the scope of the embodiments of this application. This application is intended to cover these modifications and variations provided that they fall within the scope of protection defined by the following claims and their equivalent technologies.

**Claims**

1. A phase synchronization system, comprising a first radio frequency transceiver chip and a second radio frequency transceiver chip, wherein the first radio frequency transceiver chip comprises a first phase-locked loop and a first control circuit, and the second radio frequency transceiver chip comprises a second phase-locked loop;

   the first phase-locked loop is configured to generate a first local oscillator signal;
   the second phase-locked loop is configured to generate a second local oscillator signal; and
   the first control circuit is configured to: perform detection based on the first local oscillator signal and the second local oscillator signal to obtain a first phase error, generate a first control signal based on the first phase error, and perform phase control on the first phase-locked loop or the second phase-locked loop by using the first control signal.

2. The phase synchronization system according to claim 1, wherein the first control circuit comprises:
   a first phase detector, configured to perform detection based on the first local oscillator signal and the second local oscillator signal to obtain the first phase error.

3. The phase synchronization system according to claim 1 or 2, wherein the first control circuit comprises:
   a first phase controller, configured to generate the first control signal based on the first phase error, wherein the first control signal is used to control a frequency division control word of the first phase-locked loop or the second phase-locked loop.

4. The phase synchronization system according to claim 3, wherein the first phase controller is any one of a proportional controller, an integral controller, or a proportional-integral controller.

5. The phase synchronization system according to any one of claims 1 to 4, wherein the first phase-locked loop is specifically configured to:

   generate the first local oscillator signal based on a first reference clock signal; and
   the second phase-locked loop is specifically configured to:
   generate the second local oscillator signal based on the first reference clock signal.

6. The phase synchronization system according to claim 5, wherein the first phase-locked loop is specifically configured to:
   be controlled by the first control signal to generate the first local oscillator signal based on the first reference clock signal.

7. The phase synchronization system according to claim 5, where the second phase-locked loop is specifically configured to:
   be controlled by the first control signal to generate the second local oscillator signal based on the first reference clock signal.

8. The phase synchronization system according to claim 7, further comprising a third radio frequency transceiver chip, wherein the third radio frequency transceiver chip comprises a third phase-locked loop and a second control circuit;

   the third phase-locked loop is configured to generate a third local oscillator signal;
   the second control circuit is configured to: perform detection based on the third local oscillator signal and the first local oscillator signal to obtain a second phase error, and generate a second control signal based on the second phase error; and
   the first phase-locked loop is specifically configured to:
   be controlled by the second control signal to generate the first local oscillator signal based on the first reference clock signal.

9. The phase synchronization system according to claim 8, wherein the first control circuit comprises:
   a first driver, configured to: receive the first local oscillator signal, and output the driven first local oscillator signal to the second control circuit.

10. The phase synchronization system according to any one of claims 1 to 9, wherein the first control circuit comprises:
a first buffer, configured to buffer the second local oscillator signal.

11. The phase synchronization system according to any one of claims 8 to 10, wherein the first control circuit comprises:

a second phase detector, configured to perform detection based on the third local oscillator signal and the first local oscillator signal to obtain a third phase error; and
when generating the second control signal, the second control circuit is specifically configured to:
generate the second control signal based on a difference between the second phase error and the third phase error.

12. The phase synchronization system according to claim 11, wherein the second radio frequency transceiver chip further comprises:

a third control circuit, configured to perform detection based on the first local oscillator signal and the second local oscillator signal to obtain a fourth phase error; and
when generating the first control signal, the first control circuit is specifically configured to:
generate the first control signal based on a difference between the first phase error and the fourth phase error.

13. The phase synchronization system according to claim 12, wherein the first control circuit comprises:
a second driver, configured to: receive the first local oscillator signal, and output the driven first local oscillator signal to the third control circuit.

14. The phase synchronization system according to any one of claims 11 to 13, wherein the first control circuit further comprises:
a second buffer, configured to buffer the third local oscillator signal.

15. The phase synchronization system according to any one of claims 1 to 14, wherein when performing detection based on the first local oscillator signal and the second local oscillator signal to obtain the first phase error, the first control circuit is specifically configured to:
detect a phase error between the first local oscillator signal and the second local oscillator signal, to obtain the first phase error.

16. The phase synchronization system according to any one of claims 12 to 15, wherein the first control circuit further comprises:

a first frequency divider, coupled to the first phase-locked loop, and configured to perform frequency division on the first local oscillator signal;
the third control circuit further comprises:

a second frequency divider, coupled to the second phase-locked loop, and configured to perform frequency division on the second local oscillator signal, wherein a frequency division ratio of the second frequency divider is the same as that of the first frequency divider; and
when performing detection based on the first local oscillator signal and the second local oscillator signal to obtain the first phase error, the first control circuit is specifically configured to:
detect a phase error between the first local oscillator signal obtained by performing frequency division by the first frequency divider and the second local oscillator signal obtained by performing frequency division by the second frequency divider, to obtain the first phase error.

17. The phase synchronization system according to any one of claims 5 to 16, wherein the first phase-locked loop comprises:

a third phase detector, configured to detect a phase error between the first reference clock signal and a feedback clock signal;
a loop controller, coupled to the third phase detector, and configured to generate a third control signal based on the phase error between the first reference clock signal and the feedback clock signal;

a controlled oscillator, coupled to the loop controller, and configured to generate the first local oscillator signal based on the third control signal;

a modulator, configured to generate a frequency division control word based on the first control signal or the second control signal, and a frequency control word; and

a third frequency divider, coupled to the controlled oscillator and the modulator, and configured to: generate the feedback clock signal based on the first local oscillator signal and the frequency division control word, and output the feedback clock signal to the third phase detector.

18. The phase synchronization system according to any one of claims 1 to 17, wherein the first radio frequency transceiver chip further comprises a first digital interface, the second radio frequency transceiver chip further comprises a second digital interface, and the system further comprises a control chip; and

the first digital interface is coupled to the first control circuit, and is configured to receive and output the first control signal; the control chip is coupled to the first digital interface and the second digital interface, and is configured to transmit, to the second digital interface, the first control signal output by the first digital interface; and the second digital interface is coupled to the second phase-locked loop.

19. The phase synchronization system according to any one of claims 1 to 18, wherein the first radio frequency transceiver chip further comprises:

a fourth phase-locked loop, configured to generate a fourth local oscillator signal; and

a fourth control circuit, configured to: perform detection based on the fourth local oscillator signal and the first local oscillator signal to obtain a fifth phase error, generate a fourth control signal based on the fifth phase error, and perform phase control on the first phase-locked loop or the fourth phase-locked loop by using the fourth control signal.

20. The phase synchronization system according to any one of claims 1 to 19, wherein the first radio frequency transceiver chip further comprises a plurality of first transmission channels, and the first phase-locked loop is specifically configured to provide the first local oscillator signal for the plurality of first transmission channels;

the second radio frequency transceiver chip further comprises a plurality of second transmission channels, and the second phase-locked loop is specifically configured to provide the second local oscillator signal for the plurality of second transmission channels; and

the plurality of first transmission channels and the plurality of second transmission channels are used to support multiple-input multiple-output (MIMO) transmission.

21. The phase synchronization system according to any one of claims 1 to 19, wherein the first radio frequency transceiver chip further comprises a plurality of first transmission channels, and the first phase-locked loop is specifically configured to provide the first local oscillator signal for the plurality of first transmission channels;

the second radio frequency transceiver chip further comprises a plurality of second transmission channels, and the second phase-locked loop is specifically configured to provide the second local oscillator signal for the plurality of second transmission channels; and

the plurality of first transmission channels and the plurality of second transmission channels are used to support phased array transmission.

22. A phase synchronization apparatus, comprising a first phase-locked loop and a first control circuit that are integrated into a first radio frequency transceiver chip, wherein

the first phase-locked loop is configured to generate a first local oscillator signal; and

the first control circuit is configured to: perform detection based on the first local oscillator signal and a second local oscillator signal generated by a second phase-locked loop in a second radio frequency transceiver chip, to obtain a first phase error; generate a first control signal based on the first phase error; and perform phase control on the first phase-locked loop or the second phase-locked loop by using the first control signal.

23. The phase synchronization apparatus according to claim 22, wherein the first phase-locked loop is specifically configured to:
generate the first local oscillator signal based on a first reference clock signal, wherein the first reference clock signal is a reference clock signal based on which the second phase-locked loop generates the second local oscillator signal.

24. The phase synchronization apparatus according to claim 22 or 23, wherein the first phase-locked loop is specifically configured to:
be controlled by the first control signal to generate the first local oscillator signal based on the first reference clock signal.

25. The phase synchronization apparatus according to claim 22 or 23, wherein the first phase-locked loop is specifically configured to:
be controlled by a second control signal to generate the first local oscillator signal based on the first reference clock signal, wherein the second control signal is a control signal generated by a second control circuit in a third radio frequency transceiver chip, and the second control circuit is configured to: perform detection based on the first local oscillator signal and a third local oscillator signal generated by a third phase-locked loop in the third radio frequency transceiver chip, to obtain a second phase error; and generate the second control signal based on the second phase error.

26. The phase synchronization apparatus according to any one of claims 22 to 25, wherein the apparatus further comprises a first digital interface;
the first digital interface is coupled to the first control circuit, and is configured to receive the first control signal and output the first control signal to a control chip; the control chip is coupled to the first digital interface and a second digital interface in the second radio frequency transceiver chip, and is configured to transmit, to the second digital interface, the first control signal output by the first digital interface; and the second digital interface is coupled to the second phase-locked loop.

27. The phase synchronization apparatus according to any one of claims 22 to 26, wherein the first radio frequency transceiver chip further comprises a plurality of first transmission channels, and the first phase-locked loop is specifically configured to provide the first local oscillator signal for the plurality of first transmission channels;

the second radio frequency transceiver chip further comprises a plurality of second transmission channels, and the second phase-locked loop is specifically configured to provide the second local oscillator signal for the plurality of second transmission channels; and
the plurality of first transmission channels and the plurality of second transmission channels are used to support MIMO transmission.

28. The phase synchronization apparatus according to any one of claims 22 to 26, wherein the first radio frequency transceiver chip further comprises a plurality of first transmission channels, and the first phase-locked loop is specifically configured to provide the first local oscillator signal for the plurality of first transmission channels;

the second radio frequency transceiver chip further comprises a plurality of second transmission channels, and the second phase-locked loop is specifically configured to provide the second local oscillator signal for the plurality of second transmission channels; and
the plurality of first transmission channels and the plurality of second transmission channels are used to support phased array transmission.

29. A transceiver apparatus, comprising the first radio frequency transceiver chip and the second radio frequency transceiver chip according to any one of claims 1 to 21, wherein the first radio frequency transceiver chip further comprises a plurality of first transmission channels, and a first phase-locked loop in the first radio frequency transceiver chip is specifically configured to provide a first local oscillator signal for the plurality of first transmission channels;

the second radio frequency transceiver chip further comprises a plurality of second transmission channels, and a second phase-locked loop in the second radio frequency transceiver chip is specifically configured to provide a second local oscillator signal for the plurality of second transmission channels; and
the plurality of first transmission channels and the plurality of second transmission channels are used to support MIMO transmission.

30. A transceiver apparatus, comprising the first radio frequency transceiver chip and the second radio frequency transceiver chip according to any one of claims 1 to 21, wherein the first radio frequency transceiver chip further comprises a plurality of first transmission channels, and a first phase-locked loop in the first radio frequency transceiver chip is specifically configured to provide a first local oscillator signal for the plurality of first transmission channels;

the second radio frequency transceiver chip further comprises a plurality of second transmission channels, and a second phase-locked loop in the second radio frequency transceiver chip is specifically configured to provide a second local oscillator signal for the plurality of second transmission channels; and
the plurality of first transmission channels and the plurality of second transmission channels are used to support phased array transmission.

FIG. 1

FIG. 2

FIG. 3

FIG. 4

FIG. 5

FIG. 6A

CONT.
FROM
FIG. 6A

**Chip 2**

**RX1** MIX
RX1_RF → LNA → ⊗ → ABB → ADC → RX1_BBI
⊗ → ABB → ADC → RX1_BBQ

⋮

**RXn** MIX
RXn_RF → LNA → ⊗ → ABB → ADC → RXn_BBI
⊗ → ABB → ADC → RXn_BBQ

RX LO

Phase synchronization apparatus

Phase synchronization apparatus

TX LO

**TX1** MOD
TX1_RF ← AMP ← ⊕ ⊗ ← ABB ← DAC ← TX1_BBI
⊗ ← ABB ← DAC ← TX1_BBQ

⋮

**TXm** MOD
TXm_RF ← AMP ← ⊕ ⊗ ← ABB ← DAC ← TXm_BBI
⊗ ← ABB ← DAC ← TXm_BBQ

FIG. 6B

700

Phase synchronization system

First radio frequency transceiver chip

701

702

First phase-locked loop

First control circuit

Second radio frequency transceiver chip

703

Second phase-locked loop

FIG. 7

FIG. 8

FIG. 9

701

First phase-locked loop

First local oscillator signal

Reference clock signal → Third phase detector → Loop controller → Third control signal → Controlled oscillator → First local oscillator signal

Feedback clock signal ← Third frequency divider

Frequency control word

First control signal/Second control signal → Modulator → Frequency division control word

FIG. 10

FIG. 11

FIG. 12A

CONT.
FROM
FIG. 12A

CONT.
FROM
FIG. 12A

**Chip 3**

To TX & RX

CLK_REF

PH_TUNE

PC-PLL

LO

FDIV

LO_DIV

DRV

PH_CTRL

CTRL

PH_ERR

PD 1

LO_IN

LPC

BUF

FIG. 12B

FIG. 13A

FIG. 13B

FIG. 14A

FIG. 14B

FIG. 15A

FIG. 15B

1600

Phase synchronization apparatus

1601

1602

| First phase-locked loop | First control circuit |

FIG. 16

Transceiver apparatus

First radio frequency
transceiver chip

Second radio frequency
transceiver chip

FIG. 17

## INTERNATIONAL SEARCH REPORT

| International application No. |
| --- |
| **PCT/CN2019/089705** |

**A. CLASSIFICATION OF SUBJECT MATTER**

H03L 7/099(2006.01)i; H03L 7/18(2006.01)i

According to International Patent Classification (IPC) or to both national classification and IPC

**B. FIELDS SEARCHED**

Minimum documentation searched (classification system followed by classification symbols)

H03L

Documentation searched other than minimum documentation to the extent that such documents are included in the fields searched

Electronic data base consulted during the international search (name of data base and, where practicable, search terms used)

VEN; CNABS; CNTXT; TWTXT; EPTXT; USTXT; WOTXT; JPTXT; CNKI: 芯片, 第二, 射频, 检测, 同步, 相位, 锁相环, 相位差, 多个, 同步, IC, second, radio, detect+, synchroniz+, phase, PLL, lock, number, multi+, lot, PD

**C. DOCUMENTS CONSIDERED TO BE RELEVANT**

| Category* | Citation of document, with indication, where appropriate, of the relevant passages | Relevant to claim No. |
| --- | --- | --- |
| A | CN 107347006 A (ANALOG DEVICES, INC.) 14 November 2017 (2017-11-14) description, paragraphs [0007]-[0201] | 1-30 |
| A | CN 107786764 A (SAMSUNG ELECTRONICS CO., LTD.) 09 March 2018 (2018-03-09) entire document | 1-30 |
| A | US 6765977 B1 (CISCO TECHNOLOGY, INC.) 20 July 2004 (2004-07-20) entire document | 1-30 |
| A | CN 1345482 A (ERICSSON INC.) 17 April 2002 (2002-04-17) entire document | 1-30 |
| A | CN 105656484 A (THE 26TH RESEARCH INSTITUTE OF CHINA ELECTRONICS TECHNOLOGY GROUP CORPORATION) 08 June 2016 (2016-06-08) entire document | 1-30 |
| A | CN 104426544 A (NXP B.V.) 18 March 2015 (2015-03-18) entire document | 1-30 |
| A | CN 105790760 A (INFINEON TECHNOLOGIES AG) 20 July 2016 (2016-07-20) entire document | 1-30 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **26 February 2020** | **09 March 2020** |

| Name and mailing address of the ISA/CN | Authorized officer |
| --- | --- |
| **China National Intellectual Property Administration (ISA/CN)** **No. 6, Xitucheng Road, Jimenqiao Haidian District, Beijing 100088** **China** | |
| Facsimile No. **(86-10)62019451** | Telephone No. |

Form PCT/ISA/210 (second sheet) (January 2015)

## INTERNATIONAL SEARCH REPORT

| International application No. |
| --- |
| **PCT/CN2019/089705** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 107017877 A (NXP B.V.) 04 August 2017 (2017-08-04)<br>        entire document | 1-30 |
| A | US 2011032040 A1 (HARRIS CORPORATION) 10 February 2011 (2011-02-10)<br>        entire document | 1-30 |
| A | CN 108737000 A (SHANGHAI NOKIA BELL CO., LTD.) 02 November 2018 (2018-11-02)<br>        entire document | 1-30 |

Form PCT/ISA/210 (second sheet) (January 2015)

**INTERNATIONAL SEARCH REPORT**
Information on patent family members

International application No.

**PCT/CN2019/089705**

| Patent document cited in search report | | | Publication date (day/month/year) | Patent family member(s) | | | Publication date (day/month/year) |
|---|---|---|---|---|---|---|---|
| CN | 107347006 | A | 14 November 2017 | US | 2017324419 | A1 | 09 November 2017 |
| | | | | US | 9979408 | B2 | 22 May 2018 |
| | | | | EP | 3242403 | A1 | 08 November 2017 |
| | | | | US | 2018294817 | A1 | 11 October 2018 |
| | | | | TW | 201740685 | A | 16 November 2017 |
| CN | 107786764 | A | 09 March 2018 | US | 2018323820 | A1 | 08 November 2018 |
| | | | | KR | 20180023741 | A | 07 March 2018 |
| | | | | US | 2018062692 | A1 | 01 March 2018 |
| | | | | US | 10050661 | B2 | 14 August 2018 |
| | | | | US | 10516433 | B2 | 24 December 2019 |
| | | | | TW | 201817205 | A | 01 May 2018 |
| US | 6765977 | B1 | 20 July 2004 | None | | | |
| CN | 1345482 | A | 17 April 2002 | AT | 255296 | T | 15 December 2003 |
| | | | | JP | 2002541707 | A | 03 December 2002 |
| | | | | DE | 60006792 | D1 | 08 January 2004 |
| | | | | EP | 1166447 | A1 | 02 January 2002 |
| | | | | AU | 4038400 | A | 23 October 2000 |
| | | | | WO | 0060741 | A1 | 12 October 2000 |
| | | | | CN | 1225088 | C | 26 October 2005 |
| | | | | TR | 200102834 | T2 | 22 April 2002 |
| | | | | EP | 1166447 | B1 | 26 November 2003 |
| | | | | US | 6091303 | A | 18 July 2000 |
| CN | 105656484 | A | 08 June 2016 | None | | | |
| CN | 104426544 | A | 18 March 2015 | US | 2015063517 | A1 | 05 March 2015 |
| | | | | CN | 104426544 | B | 25 May 2018 |
| | | | | EP | 2843840 | A1 | 04 March 2015 |
| | | | | US | 9014323 | B2 | 21 April 2015 |
| | | | | EP | 2843840 | B1 | 13 November 2019 |
| CN | 105790760 | A | 20 July 2016 | CN | 105790760 | B | 13 November 2018 |
| | | | | DE | 102016100497 | A1 | 14 July 2016 |
| | | | | KR | 101840919 | B1 | 21 March 2018 |
| | | | | US | 2016204784 | A1 | 14 July 2016 |
| | | | | KR | 20160087764 | A | 22 July 2016 |
| | | | | US | 9866222 | B2 | 09 January 2018 |
| CN | 107017877 | A | 04 August 2017 | US | 10003343 | B2 | 19 June 2018 |
| | | | | EP | 3197056 | B1 | 01 August 2018 |
| | | | | US | 2017214407 | A1 | 27 July 2017 |
| | | | | EP | 3197056 | A1 | 26 July 2017 |
| US | 2011032040 | A1 | 10 February 2011 | US | 8013681 | B2 | 06 September 2011 |
| CN | 108737000 | A | 02 November 2018 | None | | | |

Form PCT/ISA/210 (patent family annex) (January 2015)